# EUROPEAN PATENT APPLICATION

(11) **EP 2 858 347 A1**
(43) Date of publication of application: **08.04.2015**
(21) Application number: 13796480.5
(22) Date of filing: 27.05.2013
(51) Int. Cl.: H04N 5/32, A61B 6/00, G01T 1/24, G01T 7/00, H01L 27/144, H01L 27/146, H04N 5/343, H04N 5/347, H04N 5/374, H04N 5/376

(54) **RADIOGRAPHIC IMAGING EQUIPMENT, RADIOGRAPHIC IMAGING SYSTEM, CONTROL METHOD FOR RADIOGRAPHIC IMAGING EQUIPMENT, AND CONTROL PROGRAM FOR RADIOGRAPHIC IMAGING EQUIPMENT**

(30) Priority: 30.05.2012 JP 2012123626
(71) Applicant: FUJIFILM CORPORATION, Minato-ku Tokyo 106-8620 (JP)
(72) Inventor: OKADA, Yoshihiro, Ashigarakami-gun Kanagawa 258-0023 (JP)
(74) Representative: Klunker . Schmitt-Nilson . Hirsch
(86) International application number: PCT/JP2013/064672
(87) International publication number: WO 2013/180076

(57) **Abstract**

Radiation images with different resolutions may be captured using a general-purpose driver configured with a shift register group in a single system. Each shift register is connected to a first gate line or a second gate line via a connection terminal in accordance with wiring of a radiation detector 26. Under the control of an FPGA, in a case of low resolution imaging, a panel control section outputs OE signals that disable the output of on signals from the shift registers to the first gate lines in accordance with CPK signals. In a case of high resolution imaging, the panel control section outputs OE signals that disable the output of on signals from the shift registers to the second gate lines 137. In both cases, an on signal outputted from a shift register is inputted to a succeeding shift register.

## Description

### TECHNICAL FIELD

The present invention relates to a radiation imaging device, a radiation imaging system, a radiation imaging device control method, and a radiation imaging device control program. In particular, the present invention relates to a radiation imaging device, radiation imaging system, radiation imaging device control method, and radiation imaging device control program that may capture radiation images with different resolutions.

### BACKGROUND ART

Heretofore, a radiation imaging device has been known that, to capture a radiation image, detects radiation that has been irradiated from a radiation irradiation device and has passed through an imaging subject, with a radiation detector.

This radiation imaging device is equipped with the radiation detector that detects radiation. The radiation imaging device includes photoelectric conversion elements and a panel (the radiation detector). The photoelectric conversion elements generate electric charges when irradiated with radiation or illuminated with light converted from radiation. The radiation detector includes storage capacitances that retain and accumulate the charges generated by the photoelectric conversion elements, and switching elements that read out the charges from the storage capacitances and output electronic signals corresponding to the charges.

Radiation imaging devices that may capture radiation images with different resolutions are known. These radiation imaging devices include a device in which each pixel includes a switching element for high resolution, which is driven when a radiation image is being captured at a high resolution, and a switching element for low resolution, which is driven when a radiation image is being captured at a low resolution. A device that is equipped with two drivers is known as this kind of radiation imaging device. The two drivers are: a driver that includes a group of shift registers that sequentially output driving signals that drive the switching elements for high resolution to gate lines for high resolution; and a driver that includes a group of shift registers that sequentially output driving signals that drive the switching elements for low resolution to gate lines for low resolution. In this radiation imaging device, because the drivers are connected at two sides of the radiation detector (the sides of two end portions of a face on which radiation is irradiated), the exterior of the radiation imaging device is larger.

Consequently, there have been calls for a radiation imaging device in which drivers are connected at one side of a radiation detector. For example, a radiation imaging device recited in Japanese Patent Application Laid-Open (JP-A) No. 2004-46143 is known. In the radiation imaging device recited in JP-A No. 2004-46143, the interior of a gate driver circuit section is provided with two separate systems, a system corresponding with the gate lines for high resolution and a system corresponding with the gate lines for low resolution, and each system may be driven independently.

### DISCLOSURE OF INVENTION

### TECHNICAL PROBLEM

However, in the radiation imaging device recited in JP-A No. 2004-46143, because shift register groups are provided for the two systems, the structure of the drivers may become complicated. A gate driver is generally connected with a radiation detector via connection terminals in the form of a film, using a Chip On Film (COF) or a Tape Carrier Package (TCP). The pitch of gate terminals of the switching elements of the pixels of a radiation detector is of the order of 100 µm or less. In a case in which a gate driver is provided for each of shift register group systems, alternatingly connecting gate drivers within such a pitch is difficult, and is problematic to achieve in practice.

Moreover, there are cases in which a special-purpose gate driver must be provided for the radiation imaging device recited in JP-A No. 2004-46143. In a case in which this special-purpose gate driver is provided, development costs are expensive, production volumes are very small due to being for a special purpose, and the component cost may be very high.

An object of the present invention is to provide a radiation imaging device, a radiation imaging system, a radiation imaging device control method, and a radiation imaging device control program that may capture radiation images with different resolutions using a general-purpose driver configured with a shift register group in a single system.

### SOLUTION TO PROBLEM

A first aspect of the present invention is a radiation imaging device including: a plural number of pixels arrayed in a two-dimensional pattern, each pixel including a sensor portion that generates charges in accordance with irradiated radiation, a first switching element that, in accordance with driving signals, reads out the charges from the sensor portion and outputs the charges, and a second switching element that, in accordance with driving signals, reads out the charges from the sensor portion and outputs the charges; a control line group including a plural number of first control lines connected to control terminals of the first switching elements of plural numbers of the pixels that are adjacent in a first direction according to the array of the pixels, and a plural number of second control lines connected to control terminals of the second switching elements of plural numbers of the pixels that are adjacent in the first direction and to control terminals of the second switching elements of the pixels that are adjacent in a second direction crossing the first direction; a signal line group including a signal line for each pixel in the second direction, output terminals of the first switching elements of plural numbers of the pixels that are adjacent in the second direction being connected to each of the signal lines, and output terminals of the second switching elements of plural numbers of the pixels that are adjacent in the second direction and output terminals of the second switching elements of plural numbers of the pixels that are adjacent in the first direction being connected to some of the signal lines; a driver including a shift register group that sequentially outputs driving signals to the control lines in accordance with inputted clock signals; and a controller that, in a case of reading charges with the first switching elements, controls such that driving signals outputted from the shift registers are outputted to the first control lines but are not outputted to the second control lines and, in a case of reading charges with the second switching elements, controls such that the driving signals outputted from the shift registers are not outputted to the first control lines but are outputted to the second control lines.

In a second aspect of the present invention, in the first aspect described above, in the case of reading charges with the second switching elements, the controller controls to make a period of the clock signals inputted to the shift registers that correspond with the first control lines shorter than a period of the clock signals inputted to the shift registers that correspond with the second control lines.

In a third aspect of the present invention, in the first aspect or second aspect described above, in the case of reading charges with the first switching elements, the controller controls to make a period of the clock signals inputted to the shift registers that correspond with the second control lines shorter than a period of the clock signals inputted to the shift registers that correspond with the first control lines.

In a fourth aspect of the present invention, in any of the first to third aspects described above, a plural number of the shift registers that output driving signals to the first control lines are adjacent, and a plural number of the shift registers that output driving signals to the second control lines are adjacent.

In a fifth aspect of the present invention, in any of the first to third aspects described above, the first control lines and second control lines provided in accordance with the array of the pixels are interchanged in a sequence of connection to the driver, a plural number of the shift registers that output driving signals to the first control lines are adjacent, and a plural number of the shift registers that output driving signals to the second control lines are adjacent.

In a sixth aspect of the present invention, in any of the first to fifth aspects described above, in the case of reading charges with the first switching elements, the controller outputs disable signals to the shift registers that correspond with the second control lines in accordance with the inputted clock signals, the disable signals disabling output to the second control lines of the driving signals outputted from the shift registers, and, in the case of reading charges with the second switching elements, the controller outputs disable signals to the shift registers that correspond with the first control lines in accordance with the inputted clock signals, the disable signals disabling output to the first control lines of the driving signals outputted from the shift registers.

In a seventh aspect of the present invention, in any of the first to sixth aspects described above, the controller includes a frequency divider, and the controller inputs the clock signals to the shift registers via the frequency divider in cases in which the period of the clock signals is to be made shorter.

An eighth aspect of the present invention is a radiation imaging system including: a radiation irradiation device; and a radiation imaging device according to any one of claims 1 to 7 that detects radiation irradiated from the radiation irradiation device.

A ninth aspect of the present invention is a control method of a radiation imaging device that includes: a plural number of pixels arrayed in a two-dimensional pattern, each pixel including a sensor portion that generates charges in accordance with irradiated radiation, a first switching element that, in accordance with driving signals, reads out the charges from the sensor portion and outputs the charges, and a second switching element that, in accordance with driving signals, reads out the charges from the sensor portion and outputs the charges; a control line group including a plural number of first control lines connected to control terminals of the first switching elements of plural numbers of the pixels that are adjacent in a first direction according to the array of the pixels, and a plural number of second control lines connected to control terminals of the second switching elements of plural numbers of the pixels that are adjacent in the first direction and to control terminals of the second switching elements of the pixels that are adjacent in a second direction crossing the first direction; a signal line group including a signal line for each pixel in the second direction, output terminals of the first switching elements of plural numbers of the pixels that are adjacent in the second direction being connected to each of the signal lines, and output terminals of the second switching elements of plural numbers of the pixels that are adjacent in the second direction and output terminals of the second switching elements of plural numbers of the pixels that are adjacent in the first direction being connected to some of the signal lines; and a driver including a shift register group that sequentially outputs driving signals to the control lines in accordance with inputted clock signals, the radiation imaging device control method including: in a case of reading charges with the first switching elements, controlling with a controller such that driving signals outputted from the shift registers are outputted to the first control lines but are not outputted to the second control lines; and, in a case of reading charges with the second switching elements, controlling with the controller such that the driving signals outputted from the shift registers are not outputted to the first control lines but are outputted to the second control lines.

A tenth aspect of the present invention is a control program of a radiation imaging device that includes: a plural number of pixels arrayed in a two-dimensional pattern, each pixel including a sensor portion that generates charges in accordance with irradiated radiation, a first switching element that, in accordance with driving signals, reads out the charges from the sensor portion and outputs the charges, and a second switching element that, in accordance with driving signals, reads out the charges from the sensor portion and outputs the charges; a control line group including a plural number of first control lines connected to control terminals of the first switching elements of plural numbers of the pixels that are adjacent in a first direction according to the array of the pixels, and a plural number of second control lines connected to control terminals of the second switching elements of plural numbers of the pixels that are adjacent in the first direction and to control terminals of the second switching elements of the pixels that are adjacent in a second direction crossing the first direction; a signal line group including a signal line for each pixel in the second direction, output terminals of the first switching elements of plural numbers of the pixels that are adjacent in the second direction being connected to each of the signal lines, and output terminals of the second switching elements of plural numbers of the pixels that are adjacent in the second direction and output terminals of the second switching elements of plural numbers of the pixels that are adjacent in the first direction being connected to some of the signal lines; and a driver including a shift register group that sequentially outputs driving signals to the control lines in accordance with inputted clock signals, the radiation imaging device control program causing a computer to function as a controller that performs control including: in a case of reading charges with the first switching elements, controlling such that driving signals outputted from the shift registers are outputted to the first control lines but are not outputted to the second control lines; and, in a case of reading charges with the second switching elements, controlling such that the driving signals outputted from the shift registers are not outputted to the first control lines but are outputted to the second control lines.

### ADVANTAGEOUS EFFECTS OF INVENTION

According to the present invention, an effect is provided in that radiation images may be captured at different resolutions with a general-purpose driver configured with a shift register group in a single system.

### BRIEF DESCRIPTION OF DRAWINGS

Fig. 1 is a schematic structural diagram of the whole of an example of a radiation imaging system in accordance with a first exemplary embodiment.
Fig. 2 is a structural diagram of overall structure of the example of a radiation imaging system in accordance with the first exemplary embodiment.
Fig. 3 is a schematic diagram showing an outline of a cross section of an example of an indirect conversion-type radiation detector in accordance with the first exemplary embodiment.
Fig. 4 is a schematic diagram showing an outline of a cross section of an example of a direct conversion-type radiation detector in accordance with the first exemplary embodiment.
Fig. 5 is a schematic structural diagram showing the general structure of an example of pixels of a radiation detector in accordance with the first exemplary embodiment, in a state in which the pixels are seen in plan view from a side from which radiation X is irradiated.
Fig. 6 is a schematic structural diagram of an example of a radiation panel unit in accordance with the first exemplary embodiment.
Fig. 7 is a schematic structural diagram showing the general structure of an example of a signal generation section, a frequency divider and a switching element in accordance with the first exemplary embodiment.
Fig. 8 is a schematic structural diagram showing the general structure of an example of a gate driver in accordance with the first exemplary embodiment.
Fig. 9 is a schematic structural diagram of an example of a signal processing section in accordance with the first exemplary embodiment.
Fig. 10 is a flowchart showing an example of control flow of an FPGA of a panel control section in accordance with the first exemplary embodiment.
Fig. 11 is a timing chart showing an example of a driving sequence at the gate driver when a period of CPK signals is being controlled in a case of low resolution imaging in accordance with the first exemplary embodiment.
Fig. 12 is a timing chart showing an example of a driving sequence at the gate driver when the period of CPK signals is being controlled in a case of high resolution imaging in accordance with the first exemplary embodiment.
Fig. 13 is a timing chart showing an example of a driving sequence at the gate driver when the CPK signals are at a usual frequency in a case of low resolution imaging in accordance with the first exemplary embodiment.
Fig. 14 is a timing chart showing an example of a driving sequence at the gate driver when the CPK signals are at the usual frequency in a case of high resolution imaging in accordance with the first exemplary embodiment.
Fig. 15 is a schematic structural diagram showing the general structure of an example of a radiation detector in accordance with a second exemplary embodiment.
Fig. 16 is a timing chart showing an example of a driving sequence at a gate driver in a case of imaging at a low resolution in accordance with the second exemplary embodiment.
Fig. 17 is a timing chart showing an example of a driving sequence at the gate driver in a case of imaging at a high resolution in accordance with the second exemplary embodiment.
Fig. 18 is a schematic structural diagram showing the general structure of a radiation detector in accordance with an alternative example of the second exemplary embodiment.

### BEST MODE FOR CARRYING OUT THE INVENTION

### - First Exemplary Embodiment -

Herebelow, an example of a present exemplary embodiment is described with reference to the attached drawings.

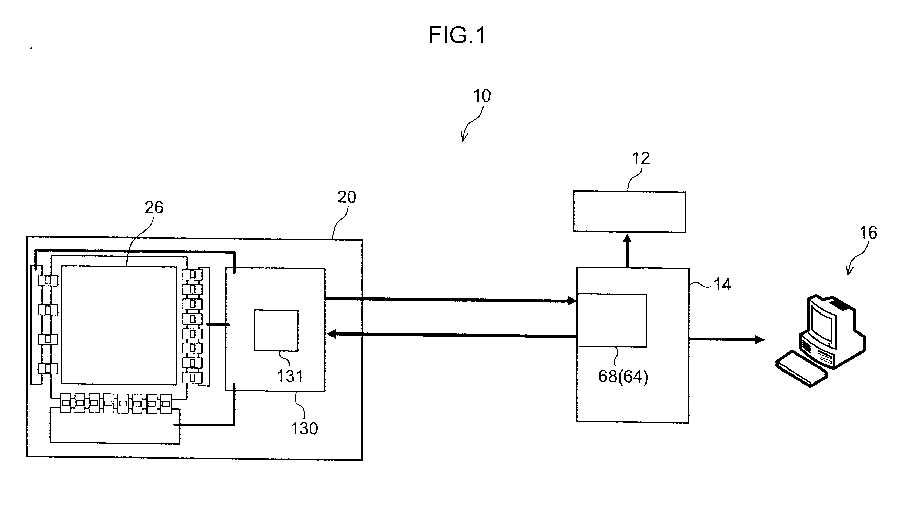

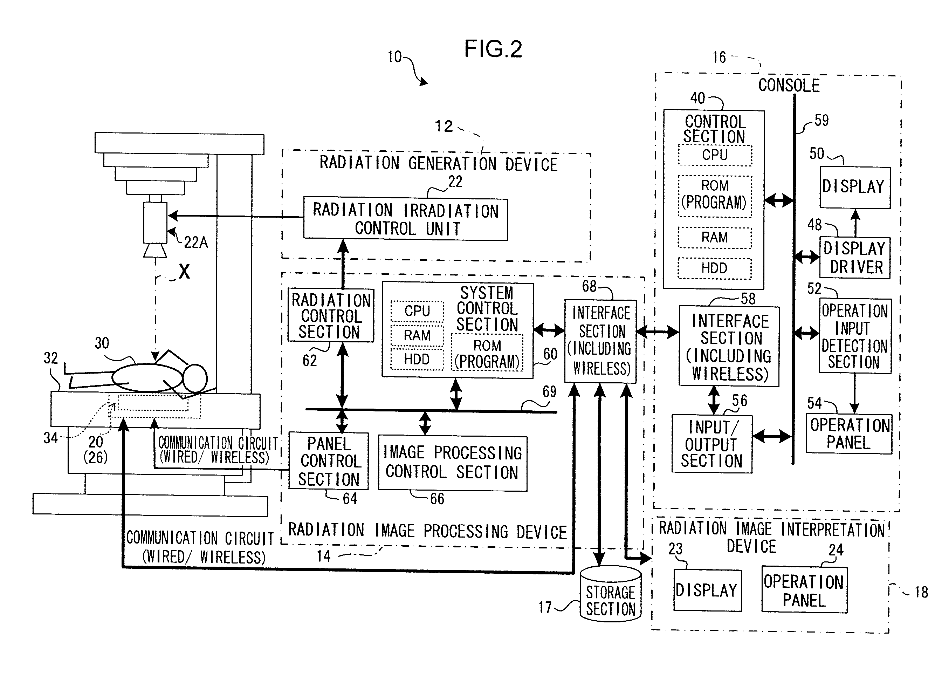

First, the overall schematic structure of a radiation imaging system including a radiation image processing device according to the present exemplary embodiment is described. Fig. 1 shows a schematic structural diagram of the whole of the radiation imaging system according to the present exemplary embodiment. Fig. 2 is a structural diagram showing the overall structure of a radiation imaging system 10 according to the present exemplary embodiment in greater detail than Fig. 1. The radiation imaging system 10 according to the present exemplary embodiment is capable of capturing radiation images at different resolutions. The radiation imaging system 10 according to the present exemplary embodiment may capture both video images and still images. In the present exemplary embodiment, unless particularly specified, the term "radiation image" refers to both video images and still images. The meaning of the term "video image" as used in the present exemplary embodiment includes successive still images being rapidly displayed so as to be interpreted as moving images, in which a process of capturing a still image, converting it to electronic signals, transferring the electronic signals, and replaying the still image from the electronic signals is rapidly repeated. Thus, depending on a degree of "rapidity", imaging of (a portion or the whole of) the same region a plural number of times in a pre-specified duration and successively replaying the images, which is known as "frame advance", is also encompassed by the term "video image".

The radiation image capture system 10 according to the present exemplary embodiment includes functions for capturing radiation images in response to operations by doctors, radiographers and the like on the basis of instructions (imaging menu selections) inputted from an external system (for example, a radiology information system (RIS)) via a console 16.

The radiation imaging system 10 according to the present exemplary embodiment also includes functions that enable doctors, radiographers and the like to interpret radiation images, by displaying captured radiation images at a display 50 of the console 16 or at a radiation image interpretation device 18 or the like.

The radiation imaging system 10 according to the present exemplary embodiment includes a radiation generation device 12, a radiation image processing device 14, the console 16, a storage section 17, the radiation image interpretation device 18, and a radiation panel unit 20.

The radiation generation device 12 includes a radiation irradiation control unit 22. The radiation irradiation control unit 22 includes a function for causing an irradiation of radiation X from a radiation irradiation source 22A, at an imaging target region of an imaging subject 30 on an imaging table 32, in accordance with control by a radiation control section 62 of the radiation image processing device 14.

Radiation X that passes through the imaging subject 30 is irradiated onto the radiation panel unit 20, which is retained at a retention portion 34 inside the imaging table 32. The radiation panel unit 20 includes functions for generating electric charges in accordance with doses of the radiation X passing through the imaging subject 30, generating image information representing a radiation image based on the generated charge amounts, and outputting the image information. The radiation panel unit 20 according to the present exemplary embodiment includes a radiation detector 26 and a panel control section 130. The panel control section 130 includes functions for control of the radiation panel unit 20 as a whole by a field programmable gate array (FPGA) 131. The radiation detector 26 according to the present exemplary embodiment may capture radiation images with different resolutions.

In the present exemplary embodiment, image information representing a radiation image that is outputted by the radiation panel unit 20 is inputted to the radiation image processing device 14 via an optical fiber, a CAMERA LINK compliant connection or the like, and is inputted via the radiation image processing device 14 to the console 16. The console 16 according to the present exemplary embodiment includes functions for controlling the radiation generation device 12 and the radiation panel unit 20, using imaging menu selections and various other kinds of information acquired from the external system (the RIS) or the like via a wireless network (a local area network (LAN)) or the like. The console 16 according to the present exemplary embodiment also includes functions for exchanging various kinds of information such as image information of radiation images with the radiation image processing device 14, and functions for exchanging various kinds of information with the radiation panel unit 20.

The console 16 according to the present exemplary embodiment is a server computer. The console 16 includes a control section 40, a display driver 48, the display 50, an operation input detection section 52, an operation panel 54, an input/output section 56 and an interface section 58.

The control section 40 includes functions for controlling overall operations of the console 16, and is provided with a central processing unit (CPU), ROM, RAM and a hard disk drive (HDD). The CPU includes functions for controlling overall operations of the console 16. Various programs, including a control program to be used at the CPU, and suchlike are pre-memorized in the ROM. The RAM includes functions for temporarily storing various kinds of data. The HDD includes functions for storing and retaining various kinds of data.

The display driver 48 includes functions for controlling the display of various kinds of information at the display 50. The display 50 according to the present exemplary embodiment includes functions for displaying imaging menu items, captured radiation images and the like. The operation input detection section 52 includes functions for detecting operation states of the operation panel 54. The operation panel 54 is for doctors, radiographers and the like to input operation instructions in relation to the imaging of radiation images. The operation panel 54 according to the present exemplary embodiment includes, for example, a touch panel, a touch pen, plural buttons and a mouse, or the like. In a case in which the operation panel 54 is a touch panel, it may be the same component as the display 50.

The input/output section 56 and the interface section 58 exchange various kinds of information with the radiation image processing device 14 and the radiation generation device 12 by wireless communications, and include functions for exchanging various kinds of information such as image information with the radiation panel unit 20.

The control section 40, the display driver 48, the operation input detection section 52 and the input/output section 56 are connected to be able to transfer information and the like to one another via a bus 59, which is a system bus, a control bus or the like. Therefore, the control section 40 may control displays of various kinds of information at the display 50 via the display driver 48, and may control exchanges of various kinds of information with the radiation generation device 12 and the radiation panel unit 20 via the interface section 58.

The radiation image processing device 14 according to the present exemplary embodiment includes functions for controlling the radiation generation device 12 and the radiation panel unit 20 in accordance with instructions from the console 16. The radiation image processing device 14 also includes functions for memorizing radiation images received from the radiation panel unit 20 in the storage section 17 and for controlling displays at the display 50 of the console 16 and the radiation image interpretation device 18.

The radiation image processing device 14 according to the present exemplary embodiment includes a system control section 60, the radiation control section 62, a panel control section 64, an image processing control section 66 and an interface section 68.

The system control section 60 includes functions for overall control of the radiation image processing device 14 and functions for controlling the radiation image capture system 10. The system control section 60 includes a CPU, ROM, RAM and an HDD. The CPU includes functions for controlling overall operations of the radiation image processing device 14 and operations of the radiation imaging system 10. Various programs, including a control program to be used at the CPU, and suchlike are pre-memorized in the ROM. The RAM includes functions for temporarily storing various kinds of data. The HDD includes functions for storing and retaining various kinds of data. The radiation control section 62 includes functions for controlling the radiation irradiation control unit 22 of the radiation generation device 12 in accordance with instructions from the console 16. The panel control section 64 includes functions for receiving information from the radiation panel unit 20 by wireless and by wire. The image processing control section 66 includes functions for applying various kinds of image processing to radiation images.

The system control section 60, the radiation control section 62, the panel control section 64 and the image processing control section 66 are connected to be capable of transferring information and the like to one another via a bus 69, which is a system bus, a control bus or the like.

The storage section 17 according to the present exemplary embodiment includes functions for memorizing captured radiation images and information relating to the radiation images. The storage section 17 may be, for example, an HDD or the like.

The radiation image interpretation device 18 according to the present exemplary embodiment is a device that includes functions for interpretation of the captured radiation images by radiographic interpretation staff. The radiation image interpretation device 18 is not particularly limited but may be a "radiographic interpretation viewer", a console, a tablet terminal or the like. The radiation image interpretation device 18 according to the present exemplary embodiment is a personal computer. The radiation image interpretation device 18, similarly to the console 16 and the radiation image processing device 14, includes a CPU, ROM, RAM, an HDD, a display driver, a display 23, an operation input detection section, an operation panel 24, an input/output section, and an interface section. In Fig. 2, to avoid complexity in the drawing, only the display 23 and the operation panel 24 are shown of these structures; the other structures are not shown.

Now, the radiation panel unit 20 is described in detail. First, the radiation detector 26 provided in the radiation panel unit 20 is described. The radiation detector 26 according to the present exemplary embodiment is provided with a TFT substrate that includes two TFTs for each pixel.

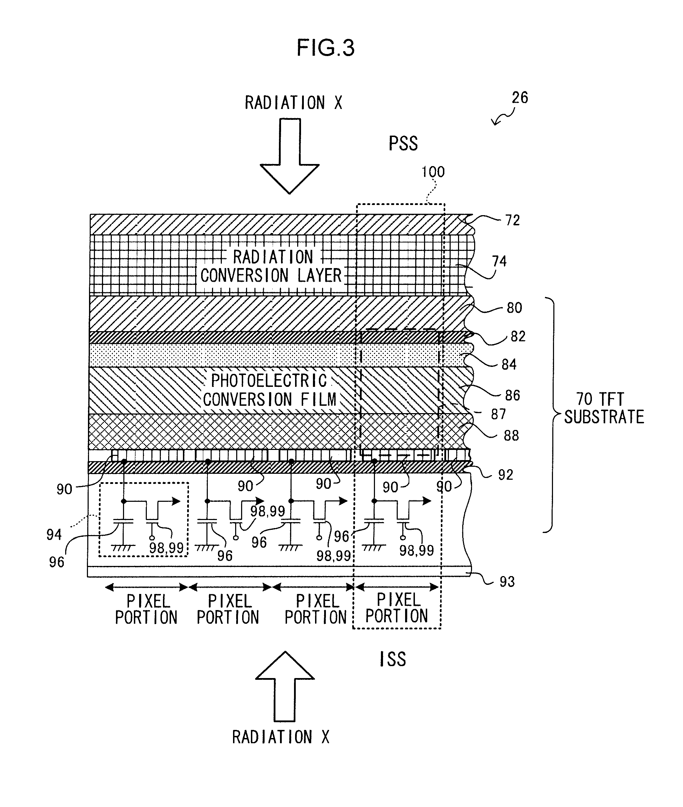

In Fig. 3, a schematic view of a cross section of an indirect conversion-type example of the radiation detector 26 is shown as an example of the radiation detector 26. The radiation detector 26 shown in Fig. 3 includes a TFT substrate 70 and a radiation conversion layer 74.

A bias electrode 72 includes a function of applying a bias voltage to a radiation conversion layer 74. In the present exemplary embodiment, the radiation detector 26 is a hole-reading sensor. Therefore, a positive bias voltage is provided to the bias electrode 72 from a high-voltage power supply, which is not shown in the drawings. In a case in which the radiation detector 26 is an electron-reading sensor that reads electrons generated in accordance with irradiated radiation X, a negative bias voltage is provided to the bias electrode 72.

The radiation conversion layer 74 is a scintillator. In the radiation detector 26 according to the present exemplary embodiment, the radiation conversion layer 74 is formed so as to be layered on a transparent insulating film 80 between the bias electrode 72 and an upper electrode 82. The radiation conversion layer 74 is formed as a film of a fluorescent material that converts radiation X that is incident from above or below to light and emits the light. Because this radiation conversion layer 74 is provided, the radiation X is absorbed and light is emitted.

The wavelength range of the light emitted by the radiation conversion layer 74 is preferably in the visible light range (wavelengths from 360 nm to 830 nm). To enable monochrome imaging by the radiation detector 26, it is more preferable if a green wavelength range is included.

As the scintillator that is used as the radiation conversion layer 74, a scintillator is desirable that produces fluorescent light with a relatively wide wavelength range, such that light in a wavelength range that can be absorbed at a TFT substrate 70 is produced. This kind of scintillator may include CsI:Na, CaWO₄, YTaO₄:Nb, BaFX:Eu (in which X is Br or Cl), LaOBr:Tm, GOS or the like. Specifically, in a case in which X-rays are used as the radiation X and imaged, it is preferable to include cesium iodide (CsI). It is particularly preferable to use cesium iodide with thallium added thereto (CsI:Tl), CsI:Na or the like, which have a light emission spectrum with a wavelength range of 400 nm to 700 nm when X-rays are irradiated thereon. CsI:Tl has a light emission peak wavelength of 565 nm, in the visible light region. If a scintillator containing CsI is to be used as the radiation conversion layer 74, it is preferable to use a scintillator that is formed with a strip-shaped columnar crystal structure by vacuum vapor deposition.

Light produced by the radiation conversion layer 74 must be incident on a photoelectric conversion film 86. Therefore, an upper electrode 82 is preferably constituted with a conductive material that is transparent at least for a wavelength of light emitted from the radiation conversion layer 74. Specifically, it is preferable to use transparent conducting oxides (TCO) which have high transparency to visible light and low resistance values. A thin metal film of gold or the like may be used as the upper electrode 82. However, if the transparency is to be 90% or above, the resistance value is likely to be high. Therefore, a TCO is more preferable. For example, ITO, IZO, AZO, FTO, SnO₂, TiO₂, ZnO₂ or the like may be preferably used. In regard to ease of processing, low resistance and transparency, ITO is the most preferable for the upper electrode 82. Herein, the upper electrode 82 may be formed as a single common electrode for all pixels, or may be divided between the individual pixels.

The photoelectric conversion film 86 includes an organic photoelectric conversion material that absorbs the light emitted by the radiation conversion layer 74 and generates charges. The photoelectric conversion film 86 includes an organic photoelectric conversion material, absorbs light emitted from the radiation conversion layer 74, and generates electric charges in accordance with the absorbed light. If the photoelectric conversion film 86 includes this organic photoelectric conversion material, the film has a sharp absorption spectrum in the visible range. Therefore, hardly any electromagnetic waves apart from the light emitted by the radiation conversion layer 74 are absorbed by the photoelectric conversion film 86. Thus, noise that is caused by radiation X such as X-rays or the like being absorbed at the photoelectric conversion film 86 may be effectively suppressed.

For the organic photoelectric conversion material of the photoelectric conversion film 86 to absorb the light emitted by the radiation conversion layer 74 most efficiently, it is preferable that the absorption peak wavelength of the organic photoelectric conversion material be as close as possible to the light emission peak wavelength of the radiation conversion layer 74. It is ideal if the absorption peak wavelength of the organic photoelectric conversion material and the light emission peak wavelength of the radiation conversion layer 74 match. However, provided a difference between the two is small, the light emitted from the radiation conversion layer 74 can be satisfactorily absorbed. In specific terms, it is preferable if a difference between the absorption peak wavelength of the organic photoelectric conversion material and the light emission peak wavelength of the radiation conversion layer 74 in response to the radiation X is not more than 10 nm, and it is more preferable if the same is not more than 5 nm. Organic photoelectric conversion materials that may satisfy these conditions include, for example, quinacridone-based organic compounds and phthalocyanine-based organic compounds. For example, an absorption peak wavelength of quinacridone in the visible region is 560 nm. Therefore, if quinacridone is used as the organic photoelectric conversion material and CsI:Tl is used as the material of the radiation conversion layer 74, the difference between the peak wavelengths may be kept to within 5 nm. Hence, charge amounts generated in the photoelectric conversion film 86 are substantially maximized.

To suppress an increase in dark current, it is preferable to provide one or other of an electron blocking film 88 and a hole blocking film 84, and it is more preferable to provide both. The electron blocking film 88 may be provided between a lower electrode 90 and the photoelectric conversion film 86. When a bias voltage is applied between the lower electrode 90 and the upper electrode 82, electrons are injected from the lower electrode 90 to the photoelectric conversion film 86. Thus, the electron blocking film 88 may suppress an increase in the dark current. An organic material with electron affinity may be used for the electron blocking film 88. The hole blocking film 84 may be provided between the photoelectric conversion film 86 and the upper electrode 82. When a bias voltage is applied between the lower electrode 90 and the upper electrode 82, holes are injected from the upper electrode 82 to the photoelectric conversion film 86. Thus, the hole blocking film 84 may suppress an increase in the dark current. An organic material with electron acceptance may be used for the hole blocking film 84.

The lower electrode 90 is plurally formed, spaced apart in the form of a grid (matrix), with one lower electrode 90 corresponding to one pixel. Each lower electrode 90 is connected to a first thin film transistor (hereinafter referred to simply as a TFT) 98, a second TFT 99 and an accumulation capacitor 96 of a signal output portion 94. An insulating film 92 is provided between the signal output portions 94 and the lower electrodes 90, and the signal output portions 94 are formed on an insulating substrate 93. The insulating substrate 93 is preferably an electrically insulative thin substrate (a substrate with a thickness of the order of tens of microns) with low absorption of the radiation X and flexibility, in order to allow the radiation X to be absorbed at the radiation conversion layer 74. Specifically, it is preferable if the insulating substrate 93 is an artificial resin, an aramid, bionanofibers, film-form glass that can be wound into a roll (ultra-thin sheet glass), or the like.

At each signal output portion 94, the accumulation capacitor 96, the first TFT 98 and the second TFT 99 are formed in correspondence with the lower electrode 90. The accumulation capacitor 96 accumulates charges migrating to the lower electrode 90. The first TFT 98 and the second TFT 99 are switching elements that convert the charges accumulated at the accumulation capacitor 96 to electronic signals and output the electronic signals. As is described in more detail below, the first TFT 98 is a TFT that is driven when a radiation image with a high resolution is being captured, and the second TFT 99 is a TFT that is driven when a radiation image with a low resolution is being captured.

A region in which the accumulation capacitor 96, the first TFT 98 and the second TFT 99 are formed includes a region that overlaps with the lower electrode 90 in plan view. To minimize a planar area of the radiation detector 26 (the pixels), it is desirable if the region in which each accumulation capacitor 96, first TFT 98 and second TFT 99 are formed is completely covered by the lower electrode 90.

The radiation detector 26 may be of a penetration side sampling (PSS) type or of an irradiation side sampling (ISS) type. PSS is a technology in which, as shown in Fig. 3, the radiation X is irradiated from the side of the radiation detector 26 at which the radiation conversion layer 74 is formed and the radiation detector 26 acquires the radiation image with the TFT substrate 70 that is provided at a rear face side relative to the face at which the radiation X is incident. In the radiation detector 26 in a case of PSS, light is more strongly emitted from the side of the radiation conversion layer 74 that is at the upper face side in Fig. 2. On the other hand, ISS is a technology in which the radiation X is irradiated from the side of the radiation detector 26 at which the TFT substrate 70 is formed and the radiation detector 26 acquires the radiation image with the TFT substrate 70 that is provided at the rear face side relative to the face at which the radiation X is incident. In the radiation detector 26 in a case of ISS, radiation X that has passed through the TFT substrate 70 is incident on the radiation conversion layer 74 and light is more strongly emitted from the side of the radiation conversion layer 74 at which the TFT substrate 70 is disposed. Charges are generated by the light produced by the radiation conversion layer 74 in photoelectric conversion portions 87 of pixels 100 provided at the TFT substrate 70. Therefore, in a case in which the radiation detector 26 is structured for ISS, light emission positions of the radiation conversion layer 74 are closer to the TFT substrate 70 than in a case in which the radiation detector 26 is structured for PSS, as a result of which the resolution of the radiation images obtained by imaging is higher.

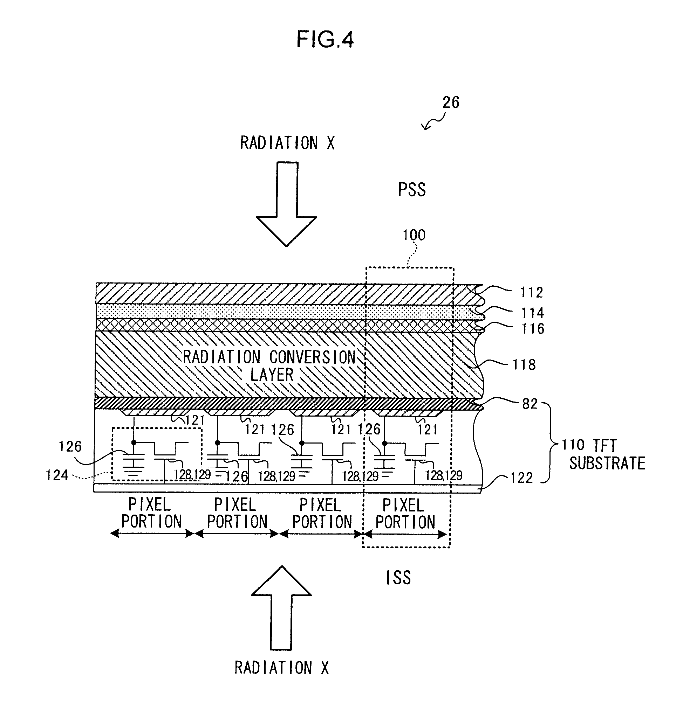

The radiation detector 26 may instead be a direct conversion type of the radiation detector 26, as illustrated by the schematic view of a cross section of an example in Fig. 4. Similarly to the indirect conversion type described above, the radiation detector 26 shown in Fig. 4 includes a TFT substrate 110 and a radiation conversion layer 118.

The TFT substrate 110 includes a function for collecting and reading out (detecting) carriers (holes), which are charges generated by the radiation conversion layer 118. The TFT substrate 110 includes an insulating substrate 122 and signal output portions 124.
In a case in which the radiation detector 26 is an electron-reading sensor, the TFT substrate 110 includes a function for collecting and reading out electrons.

The insulating substrate 122 is preferably an electrically insulative thin substrate (a substrate with a thickness of the order of tens of microns) with low absorption of the radiation X and flexibility, in order to allow the radiation X to be absorbed at the radiation conversion layer 118. Specifically, it is preferable if the insulating substrate 122 is an artificial resin, an aramid, bionanofibers, film-form glass that can be wound into a roll (ultra-thin sheet glass), or the like.

A signal detection section 85 includes an accumulation capacitance 126, a first TFT 128, a second TFT 129 and a charge collection electrode 121. The accumulation capacitor 126 is a charge accumulation capacitance. The first TFT 128 and the second TFT 129 are switching elements that convert charges accumulated at the accumulation capacitor 126 to electronic signals and output the electronic signals. As is described in more detail below, the first TFT 128 is a TFT that is operated when a radiation image with a high resolution is being captured, and the second TFT 129 is a TFT that is operated when a radiation image with a low resolution is being captured.

The charge collection electrodes 121 are plurally formed, spaced apart in the form of a grid (matrix), with one charge collection electrode 121 corresponding to one pixel. Each charge collection electrode 121 is connected to the first TFT 128, the second TFT 129 and the accumulation capacitor 126.

The accumulation capacitor 126 includes a function for accumulating charges (holes) collected by the charge collection electrode 121. The charges accumulated at the accumulation capacitor 126 are read out by the first TFT 128 or the second TFT 129. Thus, a radiation image is captured by the TFT substrate 110.

An undercoat layer 120 is formed between the radiation conversion layer 118 and the TFT substrate 110. With regard to reducing dark currents and leakage currents, the undercoat layer 120 preferably has a rectifying characteristic. Accordingly, a resistivity of the undercoat layer 120 is preferably at least 10⁸ Ω·cm, and a film thickness of the undercoat layer 120 is preferably 0.01 µm to 10 µm.

The radiation conversion layer 118 is a photoelectric conversion layer of a photoconductive material that absorbs the irradiated radiation X and generates positive and negative charges (electron-hole carrier pairs) in response to the radiation. The radiation conversion layer 118 preferably has amorphous selenium (a-Se) as a principal constituent. The radiation conversion layer 118 may use one or more of the following as a principal constituent: Bi₂MO₂₀ (M being Ti, Si or Ge), Bi₄M₃O₁₂ (M being Ti, Si or Ge), Bi₂O₃, BiMO₄ (M being Nb, Ta or V), Bi₂WO₆, Bi₂₄B₂O₃₉, ZnO, ZnS, ZnSe, ZnTe, MNbO₃ (M being Li, Na or K), PbO, HgI₂, PbI₂, CdS, CdSe, CdTe, BiI₃, GaAs, and the like. It is preferable if the radiation conversion layer 118 is a non-crystalline (amorphous) material that exhibits high resistance and excellent photoconductivity of irradiations of radiation and that can be formed into films with large areas at low temperatures by vacuum deposition.

As an example, in a case in which the photoconductive material has a-Se as a principal constituent as in the present exemplary embodiment, the thickness of the radiation conversion layer 118 is preferably in a range from 100 µm to 2000 µm. In particular, the thickness is preferably in a range from 100 µm to 250 µm for mammography applications, and in a range from 500 µm to 1200 µm for general imaging applications.

An electrode interfacial layer 116 includes a function for blocking injections of holes and a function for preventing crystallization. The electrode interfacial layer 116 is formed between the radiation conversion layer 118 and an overcoat layer 114. The electrode interfacial layer 116 is preferably an inorganic material such as CdS, CeO₂, Ta₂O₅, SiO or the like, or an organic polymer. For a layer formed of an inorganic material, it is preferable to use a composition in which carrier selectivity is adjusted by altering the composition from a stoichiometric composition or forming a multi-element composition with two or more types of elements in the same family. For a layer formed of an organic polymer, a composition in which a low-molecular electron transport material is mixed, in a weight ratio of 5% to 80%, into an insulating polymer such as a polycarbonate, polystyrene, polyimide, polycycloolefin or the like may be used. This electron transport material is preferably a material in which a carbon cluster is mixed, such as trinitrofluorene or a derivative thereof, a diphenoquinone derivative, a bis-naphthylquinone derivative, an oxazole derivative, a triazole derivative, C₆₀ (a fullerene), C₇₀ or the like. Specifically, TNF, DMDB, PBD and TAZ can be mentioned. Alternatively, a thin, insulative polymer layer may be preferably used. The insulative polymer layer is preferably, for example, parylene, polycarbonate, PVA, PVP, PVB, polyester resin, or an acrylic resin such as polymethylmethacrylate or the like. In this case, the film thickness is preferably not more than 2 µm, and more preferably not more than 0.5 µm.

The overcoat layer 114 is formed between the electrode interfacial layer 116 and a bias electrode 112. With regard to reducing dark currents and leakage currents, the overcoat layer 114 preferably has a rectifying characteristic. Accordingly, a resistivity of the overcoat layer 114 is preferably at least 10⁸ Ω·cm, and a film thickness of the overcoat layer 114 is preferably 0.01 µm to 10 µm. The bias electrode 112 is substantially the same as the bias electrode 72 of the direct conversion-type structure described above, and includes a function of applying a bias voltage to the radiation conversion layer 118.

The radiation detector 26 is not limited to the structures shown in Fig. 3 and Fig. 4; various modifications are possible. For example, in a case of PSS, probabilities of the radiation X reaching the radiation detector 26 are lower. Thus, in each signal output portion (94 or 124), instead of the structure described above, another imaging component such as a complementary metal oxide semiconductor (CMOS) image sensor or the like with low resistance to the radiation X may be combined with the TFT. Further, the signal output portion (94 or 124) may be substituted with a charge-coupled device (CCD) image sensor that shifts charges in accordance with shift pulses corresponding to TFT gate signals.

As another example, the radiation detector 26 may employ a flexible substrate. Ultra-thin plate glass formed by a recently developed float process may be used as a base material for a flexible substrate, and is preferable in terms of improving transmissivity of the radiation X. An ultrathin plate glass that may be used in this case is disclosed in, for example, "Floutohou niyoru sekai saihaku 0.1 mili-atsu no chouhaku itagarasu no kaihatsu ni seikou" (Successful development of the world's thinnest ultra-thin plate glass, 0.1 mm thick, by a float process"), Asahi Glass Co., Ltd. (online: accessed August 20, 2011, URL: http://www.agc.com/news/2011/0516.pdf).

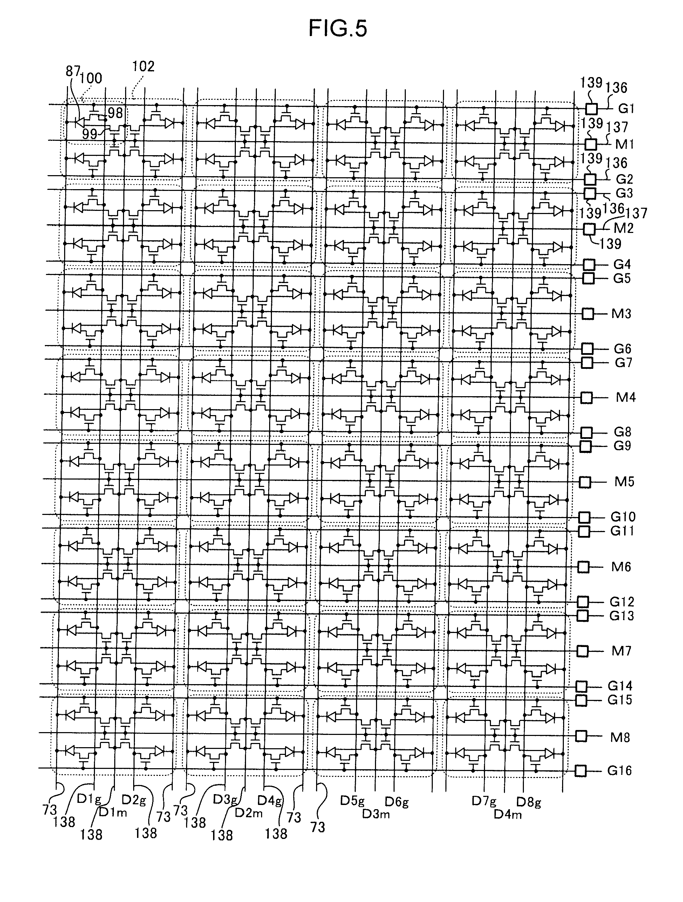

As a concrete example, the radiation detector 26 shown in Fig. 3 is illustrated in a schematic structural diagram in Fig. 5 that shows the general structure of the pixels 100 in a state in which the pixels 100 are seen in plan view from the side from which the radiation X is irradiated. As shown in Fig. 5, in the radiation detector 26 according to the present exemplary embodiment, the pixels 100 including the first TFTs 98 and the second TFTs 99 are arrayed in a two-dimensional pattern (a matrix). In Fig. 5, the arrangement of the pixels 100 is shown simplified; for example, the pixels 100 are arranged 1024 by 1024.

The radiation detector 26 is provided with a plural number of first gate lines 136 (G1 to G16 in Fig. 5) for controlling to turn the first TFTs 98 on and off, and a plural number of second gate lines 137 (M1 to M8 in Fig. 5) for controlling to turn the second TFTs 99 on and off. Herebelow, in cases in which the first gate lines 136 and the second gate lines 137 are collectively referred to, they are simply referred to as "the gate lines". A plural number of signal lines 138 are also provided (D1g to D8g and D1m to D4m in Fig. 5), which are arranged in a direction orthogonal to the gate lines and are provided one for each column of the pixels 100. Charges generated by the aforementioned photoelectric conversion portions 87 and accumulated in the accumulation capacitors 96 are read out into the signal lines 138 (D1g to D8g) by the first TFTs 98. Alternatively, charges generated by the photoelectric conversion portions 87 and accumulated in the accumulation capacitors 96 are read out into the signal lines 138 (D1m to D4m) by the second TFTs 99. In the example of the present exemplary embodiment, in the case in which 1024 by 1024 of the pixels 100 are arrayed, 1024 each of the first gate lines 136 and the signal lines 138 are provided. In this case, the second gate lines 137 are provided in half the number of the first gate lines 136; that is, 512 of the second gate lines 137 are provided.

In the radiation detector 26 according to the present exemplary embodiment, in a case in which a radiation image with a high resolution is to be captured (hereinafter referred to as "high resolution image capture"), charges are read out from each of the pixels 100 and outputted to the signal lines 138 (D1g to D8g). In the case of high resolution image capture, gate signals for turning on the first TFTs 98 of the pixels 100 (hereinafter referred to as "on signals") flow through the first gate lines 136. In response to the on signals, electronic signals according to charges read out from the pixels 100 by the first TFTs 98 flow through the signal lines 138 (D1g to D8g).

On the other hand, in a case in which a radiation image with a low resolution is to be captured (hereinafter referred to as "low resolution image capture"), charges are read out from each of pixel groups 102 and outputted to the signal lines 138 (D1m to D4m). Each pixel group 102 contains two by two of the pixels 100 that are adjacent in the direction of the second gate lines 137 and in the direction of the first gate lines 136. In the case of low resolution image capture, gate signals for turning on the second TFTs 99 of the pixels 100 (hereinafter referred to as "on signals", the same as above) flow through the second gate lines 137. In response to the on signals, electronic signals according to charges read out from the pixels 100 (the pixel groups 102) by the second TFTs 99 flow through the signal lines 138 (D1m to D4m).

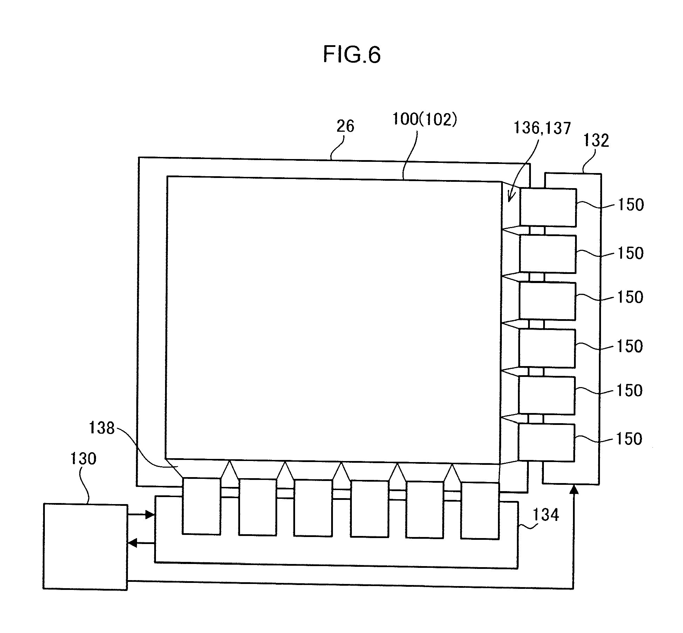

Fig. 6 shows a schematic structural diagram of the radiation panel unit 20 according to the present exemplary embodiment, which is for outputting first gate signals and second gate signals to the first gate lines 136 and the second gate lines 137. In Fig. 6, to avoid complexity in the drawing, representations of the first gate lines 136, the second gate lines 137, the signal lines 138 and the like are simplified. The radiation panel unit 20 according to the present exemplary embodiment includes a gate circuit 132 that outputs on signals to the first gate lines 136 and the second gate lines 137 under the control of the panel control section 130. The gate circuit 132 includes a plural number of gate drivers 150. The gate drivers 150 are connected to predetermined numbers of the gate lines (the first gate lines 136 and the second gate lines 137). The gate circuit 132 according to the present exemplary embodiment drives the gate drivers 150 sequentially, causing the gate drivers 150 to output on signals to the gate lines. Each gate driver 150 outputs on signals to the plural gate lines connected thereto sequentially.

In the present exemplary embodiment, the gate drivers 150 of the gate circuit 132 output on signals to the gate lines (the first gate lines 136 and the second gate lines 137) in accordance with control from the panel control section 130. Structures of the panel control section 130 and the gate circuit 132 (the gate drivers 150) for outputting on signals to the gate lines are now described.

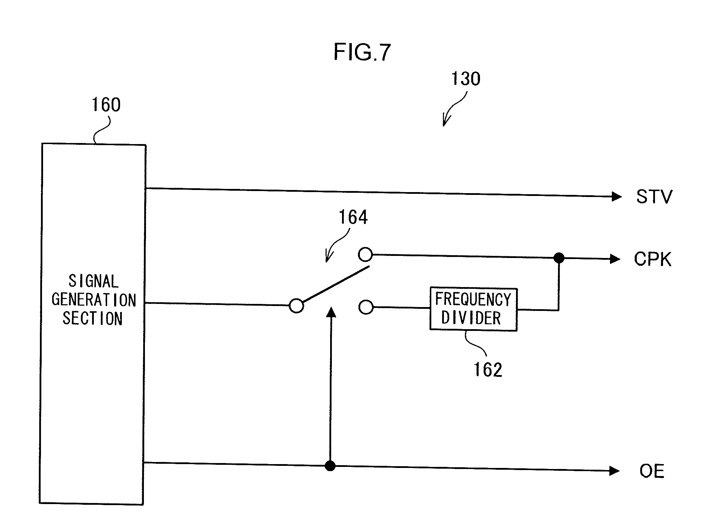

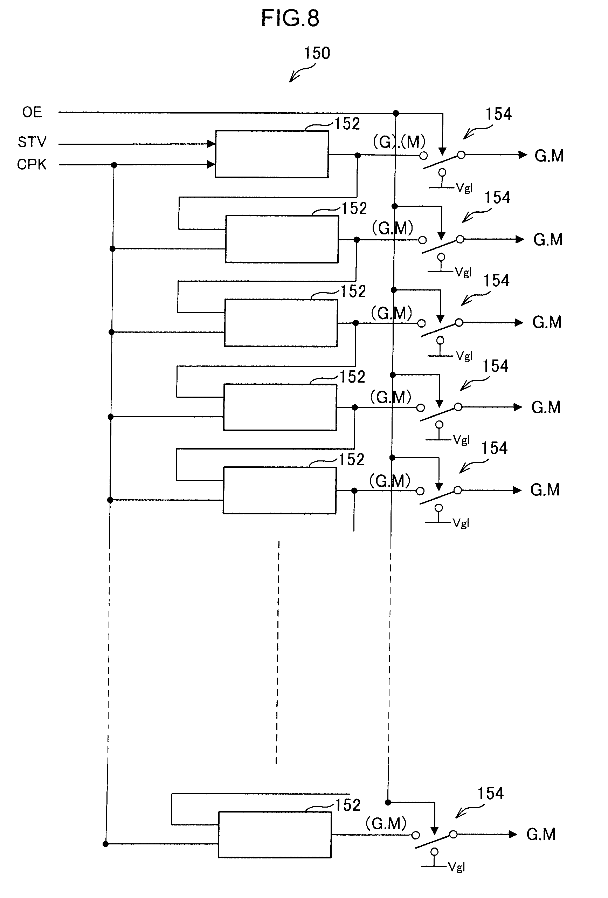

The panel control section 130 includes a signal generation section 160 and a switching element 164, for generating and outputting signals for controlling the gate circuit 132. Fig. 7 shows a schematic structural diagram of the signal generation section 160 and the switching element 164. Fig. 8 shows the schematic structure of each gate driver 150 according to the present exemplary embodiment. The gate driver 150 of the present exemplary embodiment includes one each of a shift register 152 and a switching element 154 for each gate line. Herebelow, the individual gate driver 150 is described but all of the plural gate drivers 150 provided in the gate circuit 132 are the same.

Under the control of the FPGA 131, the signal generation section 160 according to the present exemplary embodiment outputs vertical start signals STV (hereinafter referred to as "the STV signals"), clock signals CPK (hereinafter referred to as "the CPK signals") and output enable signals OE (hereinafter referred to as "the OE signals") to the gate drivers 150 of the gate circuit 132. In each gate driver 150 according to the present exemplary embodiment, the shift registers 152 output the on signals in response to the clock signals CPK. The STV signals are for causing the shift registers 152 to initially start the output of the on signals. The OE signals are for applying control such that the on signals can be outputted from the shift registers 152 to the gate lines.

In the FPGA 131 according to the present exemplary embodiment, the arrangement of the first gate lines 136 and the second gate lines 137 (the order of connection thereof to the shift registers 152) is allocated in advance. Therefore, which of the first gate lines 136 and the second gate lines 137 are caused to output on signals by which of the CPK signals may be clarified. Accordingly, the FPGA 131 controls which of the first gate lines 136 and the second gate lines 137 are to output on signals in response to the CPK signals.

In the case of high resolution imaging (the first TFTs 98 being turned on), the signal generation section 160 outputs OE signals that disable the output of the on signals to the second gate lines 137, under the control of the FPGA 131. On the other hand, in the case of low resolution imaging (the second TFTs 99 being turned on), the signal generation section 160 outputs OE signals that disable the output of the on signals to the first gate lines 136. In the gate driver 150, output destinations (connection destinations), which are the first gate lines 136 (G) or the second gate lines 137 (M), are switched by the switching elements 154 in accordance with the OE signals. In cases in which the output is not disabled, the gate signals outputted from the shift registers 152 are connected to the first gate lines 136 (G) or the second gate lines 137 (M). On the other hand, in cases in which the output is disabled, connections are made such that a potential Vgl for putting the first TFTs 98 and the second TFTs 99 into the off states thereof is applied.

Under the control of the FPGA 131, the signal generation section 160 outputs the CPK signals to the gate driver 150 via a frequency divider 162. In the present exemplary embodiment, the period of the CPK signals corresponding to the on signals whose output is disabled is shorter than a period of the CPK signals corresponding to the on signals whose output is not disabled (hereinafter referred to as a usual period). Therefore, the signal generation section 160 outputs the CPK signals corresponding to the on signals whose output is disabled to the gate driver 150 via the frequency divider 162. How much shorter the period of these signals is than the usual period may be specified in advance in accordance with specifications of the radiation panel unit 20 and suchlike. The frequency divider 162 may be set up to be capable of providing a plural number of periods, and the period may be varied to be shorter in accordance with the requirements of users and the like.

Thus, in the radiation panel unit 20 according to the present exemplary embodiment, an imaging duration for each frame may be shortened by the period of the CPK signals being made shorter than the usual period. In imaging of video images, there are cases in which a higher frame rate is required. For example, in video imaging in general, a frame rate of 15 fps is said to be adequate for images of the digestive system, 30 fps is considered adequate for images of the circulatory system, and 60 fps is considered adequate for images of children. However, with higher frame rates up to, for example, 120 fps or the like, movements of the heart and the like may be smoothly seen. In particular, a frame rate of the order of 120 fps is preferable for imaging the heart of a child. Moreover, in imaging using a radiocontrast agent, tracing may be possible with a smaller amount of the radiocontrast agent when the frame rate is higher. Using smaller doses of radiocontrast agents is preferable, because radiocontrast agents may cause side effects. Accordingly, in the radiation panel unit 20 according to the present exemplary embodiment, in a case in which the frame rate is to be made higher, the period of the CPK signals is made shorter as described above.

As shown in Fig. 8, each gate driver 150 includes a plural number of the shift registers 152, and the CPK signals are respectively inputted to the shift registers 152. Each shift register 152 is connected to either a first gate line 136 (G) or a second gate line 137 (M) by the switching element 154. In the radiation detector 26 according to the present exemplary embodiment that is shown in Fig. 5, the first gate line 136 (G1) is connected to an initial (first stage) shift register 152 and the second gate line 137 (M1) is connected to the shift register 152 of a succeeding stage. Hence, the shift registers 152 are connected in a line sequence of the gate lines of the radiation detector 26. The on signal outputted from each shift register 152 is inputted to the succeeding shift register 152. Therefore, the on signals are outputted from the gate drivers 150 to the gate lines in sequence. The first TFTs 98 or the second TFTs 99 are turned on by the on signals, and charges read out from the pixels 100 (or the pixel groups 102) are outputted to the signal lines 138.

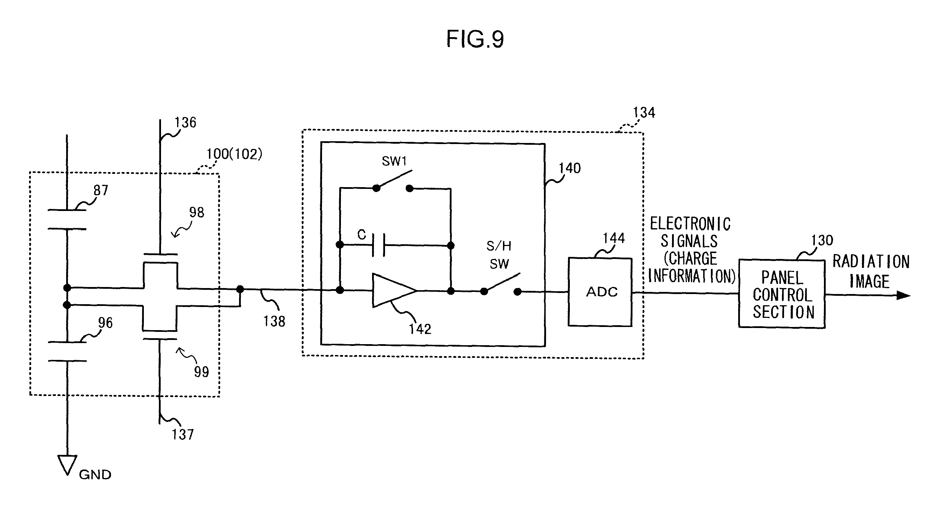

The charges (electronic signals) flowing into the signal lines 138 flow to the signal processing section 134. A schematic structural diagram of an example of the signal processing section 134 is shown in Fig. 9. The signal processing section 134 amplifies inflowing charges (analog electronic signals) with amplification circuits 140, then performs analog-to-digital (A/D) conversion with an analog-to digital-converter (ADC) 144, and outputs the electronic signals that have been converted to digital signals to the panel control section 130. Although not shown in Fig. 9, the amplification circuits 140 are provided one for each of the signal lines 138. That is, the signal processing section 134 is provided with the plural amplification circuits 140 in the same number as the number of signal lines 138 in the radiation detector 26.

Each amplification circuit 140 employs a charge amplifier circuit. The amplification circuit 140 includes an amplifier 142 such as an operational amplifier or the like, a capacitor C connected in parallel with the amplifier 142, and a switch for charge resetting SW1 that is connected in parallel with the amplifier 142. While the switches for charge resetting SW1 of the amplification circuits 140 are in the off state, charges are read out from the first TFTs 98 or second TFTs 99 of the pixels 100 (or pixel groups 102). The charges read out from the first TFTs 98 or the second TFTs 99 are accumulated at the capacitors C, and voltage values outputted from the amplifiers 142 are amplified in accordance with the accumulated charge amounts.

Then, the panel control section 130 applies charge reset signals to the switches for charge resetting SW1 and performs control to turn the switches for charge resetting SW1 on and off. When a switch for charge resetting SW1 is in the on state, the input side and output side of that amplifier 142 are short-circuited and charges are discharged from the capacitor C.

The ADC 144 includes a function for converting electronic signals that are analog signals inputted from the amplification circuits 140 to digital signals, when sample-and-hold (S/H) switches SW are in the on state. The ADC 144 sequentially outputs the electronic signals that have been converted to digital signals to the panel control section 130.

The electronic signals outputted from all the amplification circuits 140 provided in the signal processing section 134 are inputted to the ADC 144 according to the present exemplary embodiment. That is, the signal processing section 134 according to the present exemplary embodiment is provided with a single ADC 144 regardless of the number of amplification circuits 140 (and signal lines 138).

As mentioned above, the panel control section 130 according to the present exemplary embodiment includes the FPGA 131. The panel control section 130 includes functions for controlling operations of the radiation panel unit 20 as a whole so as to capture radiation images, in accordance with an imaging menu (order) that includes imaging conditions and the like for when a radiation image is being imaged. The panel control section 130 according to the present exemplary embodiment also includes a function for, when a radiation image is being imaged, controlling timings at which the gates of the first TFTs 98 and the second TFTs 99 are turned on and off.

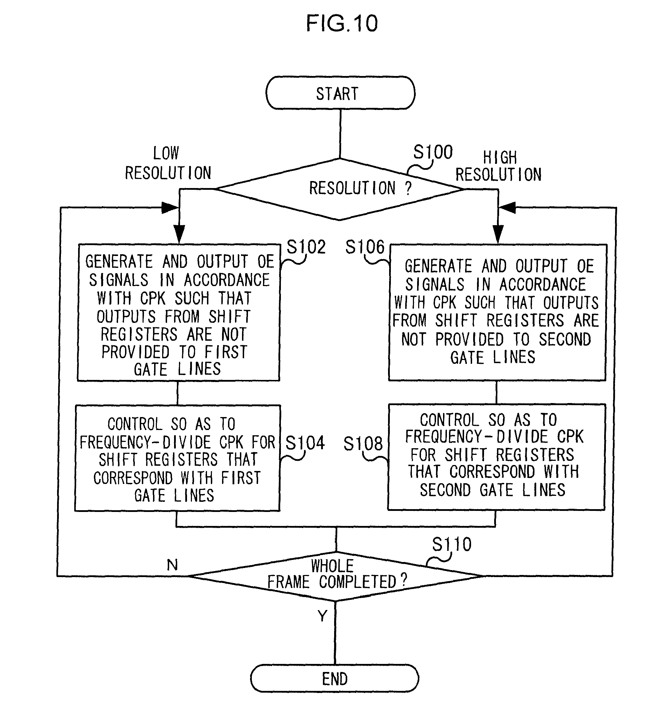

Now, a driving sequence of the gate drivers 150 of the radiation panel unit 20 according to the present exemplary embodiment is described. Fig. 10 shows a flowchart of an example of the flow of control by the FPGA 131.

The control processes shown in Fig. 10 are executed when an order representing imaging conditions is received by the panel control section 130 and imaging of a radiation image is commanded. First, in step S100, a resolution is acquired from the received order. A specification of the resolution may be included in the order as a designation of the low resolution or the high resolution, or may be specified in accordance with a type of imaging or the like.

In a case of low resolution imaging, the FPGA 131 proceeds to step S102. The low resolution imaging is imaging in which the second TFTs 99 of the pixels 100 are turned on, the first TFTs 98 are kept off, charges are read out into the signal lines 138 (Dm) from each of the pixel groups 102, and a radiation image is generated and outputted.

In step S102, the FPGA 131 controls the signal generation section 160 so as to generate and output the OE signals in accordance with the CPK signals such that outputs are not provided from the shift registers 152 to the first gate lines 136. Then, in step S104, the FPGA 131 controls the signal generation section 160 such that the CPK signals being inputted to the shift registers 152 that are connected to the first gate lines 136 are frequency-divided. Thus, the CPK signals are inputted to these shift registers 152 via the frequency divider 162. Then, in step S110, a determination is made as to whether imaging of the entire frame has been completed. If the imaging has not been completed, the result of the determination is negative, and the FPGA 131 returns to step S102 and repeats the present processing. Alternatively, if the imaging is complete, the result of the determination is affirmative and the present processing ends.

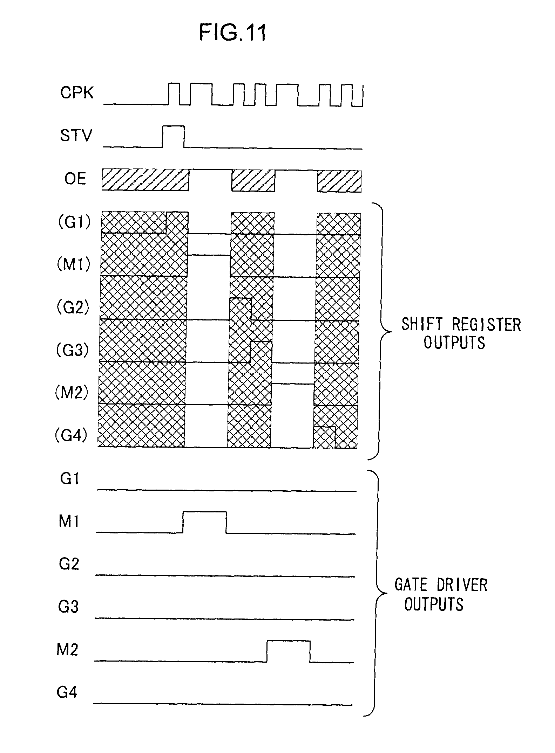

The driving sequence of the gate drivers 150 in low resolution imaging is described in detail with reference to Fig. 11. Fig. 11 is a timing chart illustrating the driving sequence of the gate drivers 150 in the case of low resolution imaging. In the present exemplary embodiment, as illustrated in Fig. 11, in cases in which the OE signals are at the low level, the output of the on signals to the gate lines is disabled, and in cases in which the OE signals are at the high level, the same output is enabled.

Firstly, the STV signal inputted to the initial (first stage) shift register 152 rises. Then, when the CPK signal rises, an on signal (G1) is outputted from the first stage shift register 152. At this time, the OE signal is at the low level. Therefore, this on signal (G1) is not outputted to the first gate line 136, and no on signal is outputted from the gate driver 150 to the first gate line 136. Accordingly, charges are not read from the pixels 100. At this time, the period of the CPK signals is shorter than the usual period.

The on signal (G1) outputted from the first shift register 152 is inputted to the succeeding shift register 152. An on signal (M1) is outputted from the succeeding shift register 152 in response to the on signal (G1) and a rise of the CPK signal. At this time, the OE signal is at the high level. Therefore, the on signal (M1) is outputted to the second gate line 137, and an on signal is outputted from the gate driver 150 to the second gate line 137. Accordingly, charges are read out from the pixel groups 102 and outputted to the signal lines 138. At this time, the period of the CPK signals is the usual period.

The on signal (M1) outputted from this second stage shift register 152 is also inputted to a succeeding shift register. Hence, the above operations are repeated sequentially along the line of shift registers 152.

Now, a case of high resolution imaging is described. In the case of high resolution imaging, the FPGA 131 proceeds from step S100 to step S106. The high resolution imaging is imaging in which the first TFTs 98 of the pixels 100 are turned on, the second TFTs 99 are kept off, charges are read out into the signal lines 138 (Dg) from each of the pixels 100, and a radiation image is generated and outputted.

In step S106, the FPGA 131 controls the signal generation section 160 so as to generate and output the OE signals in accordance with the CPK signals such that outputs are not provided from the shift registers 152 to the second gate lines 137. Then, in step S108, the FPGA 131 controls the signal generation section 160 such that the CPK signals being inputted to the shift registers 152 that are connected to the second gate lines 137 are frequency-divided. Thus, the CPK signals are inputted to these shift registers 152 via the frequency divider 162. Then, in step S110, the determination is made as to whether imaging of the entire frame has been completed. If the imaging has not been completed, the result of the determination is negative, and the FPGA 131 returns to step S102 and repeats the present processing. Alternatively, if the imaging is complete, the result of the determination is affirmative and the present processing ends.

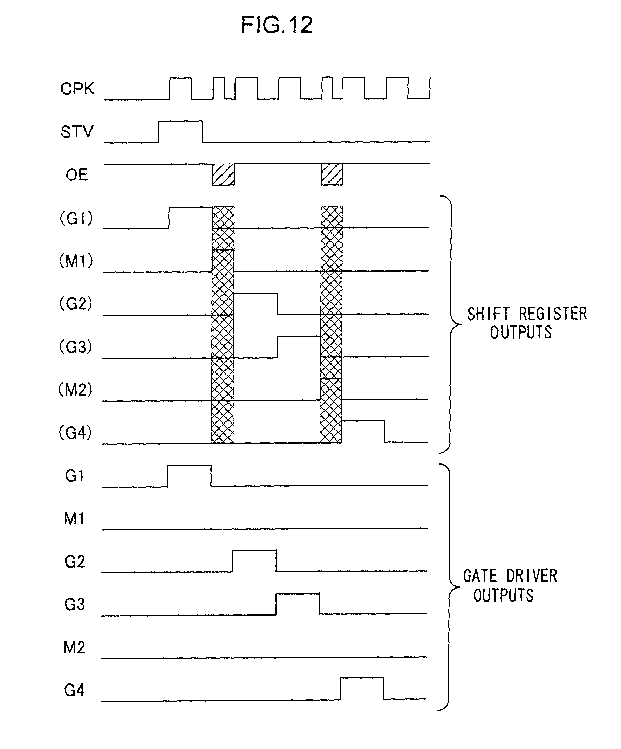

The driving sequence of the gate drivers 150 in high resolution imaging is described in detail with reference to Fig. 12. Fig. 12 is a timing chart illustrating the driving sequence of the gate drivers 150 in the case of high resolution imaging.

Firstly, the STV signal inputted to the initial (first stage) shift register 152 rises. Then, when the CPK signal rises, an on signal (G1) is outputted from the first stage shift register 152. At this time, the OE signal is at the high level. Therefore, this on signal (G1) is outputted to the first gate line 136, and an on signal is outputted from the gate driver 150 to the first gate line 136. Accordingly, charges are read out from the pixels 100 and outputted to the signal lines 138. At this time, the period of the CPK signals is the usual period.

The on signal (G1) outputted from the first shift register 152 is inputted to the succeeding shift register 152. An on signal (M1) is outputted from the succeeding shift register 152 in response to the on signal (G1) and a rise of the CPK signal. At this time, the OE signal is at the low level. Therefore, the on signal (M1) is not outputted to the second gate line 137, and no on signal is outputted from the gate driver 150 to the second gate line 137. Accordingly, charges are not read from the pixel groups 102. At this time, the period of the CPK signals is shorter than the usual period.

The on signal (M1) outputted from this second stage shift register 152 is also inputted to a succeeding shift register. Hence, the above operations are repeated sequentially along the line of shift registers 152.

Thus, the radiation panel unit 20 according to the present exemplary embodiment includes only the single gate circuit 132, and the gate circuit 132 is provided at one side of the radiation detector 26. The gate circuit 132 includes the gate drivers 150 that are provided with the shift register 152 group in a single system. Each shift register 152 is connected to a first gate line 136 or a second gate line 137 via a connection terminal 139 in accordance with the wiring of the radiation detector 26. In the case of low resolution imaging, the panel control section 130 outputs the OE signals that disable the output of on signals from the shift registers 152 to the first gate lines 136 in accordance with the CPK signals, under the control of the FPGA 131. In the case of high resolution imaging, the panel control section 130 outputs the OE signals that disable the output of on signals from the shift registers 152 to the second gate lines 137. In both cases of imaging, the on signal outputted from each shift register 152 is inputted to the succeeding shift register 152. Thus, in the case of low resolution imaging, the on signals are outputted from the gate drivers 150 only to the second gate lines 137, and in the case of high resolution imaging, the on signals are outputted from the gate drivers 150 only to the first gate lines 136.

Therefore, the radiation panel unit 20 according to the present exemplary embodiment may capture radiation images with a low resolution and with a high resolution using the general-purpose gate drivers 150 configured with the shift register 152 group in a single system.

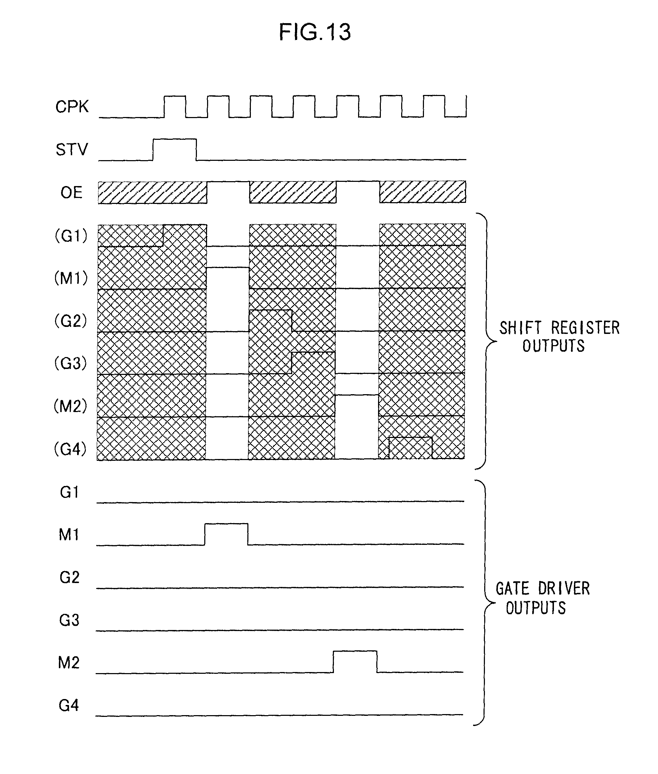

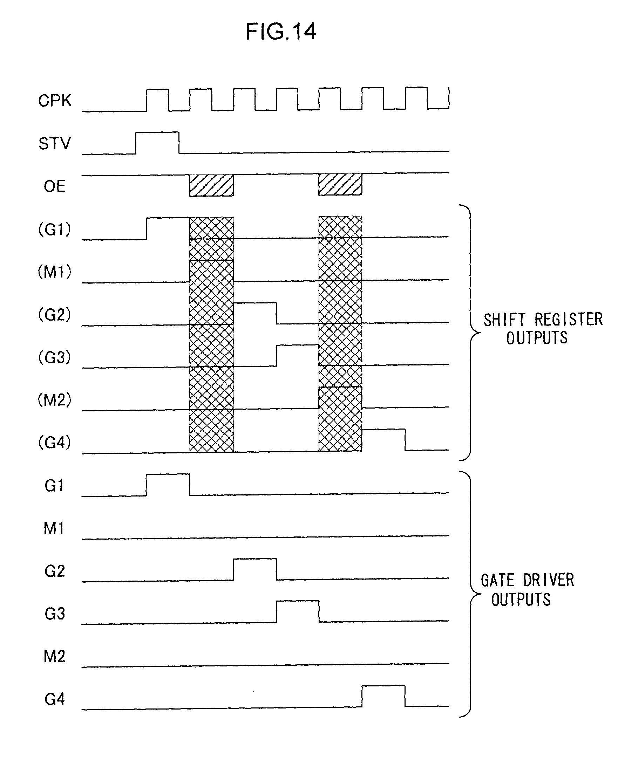

In the radiation panel unit 20 according to the present exemplary embodiment, the period of the CPK signals when the output of the on signals is being disabled by the OE signals is made shorter than the usual period by the frequency divider 162. However, this is not limiting; this period may be the usual period. For this case, Fig. 13 shows a driving sequence for low resolution imaging and Fig. 14 shows a driving sequence for high resolution imaging. In both these cases, the driving is the same as described above except that the period of the CPK signals is the usual period. In the present exemplary embodiment as described above, in both low resolution imaging and high resolution imaging, the shift registers 152 corresponding with all of the gate lines (the first gate lines 136 and the second gate lines 137) are driven. Therefore, there is a concern that the overall driving duration of the shift registers 152 may be longer than in a case in which only driving corresponding to the first gate lines 136 is conducted or a case in which only driving corresponding to the second gate lines 137 is conducted. Accordingly, in the radiation panel unit 20 according to the present exemplary embodiment, the period of the CPK signals is made shorter than the usual period in cases in which on signals are not to be outputted, and thus a lengthening of the driving duration may be suppressed and a decrease in the frame rate may be suppressed. Therefore, the radiation panel unit 20 may cope with an increase in the frame rate.

In the present exemplary embodiment, a case is described in which the switching elements 154 are provided inside the gate drivers 150, but this is not limiting. The switching elements 154 may be provided outside the gate drivers 150. Further, the switching elements 154 may be provided outside the gate circuit 132.

In the present exemplary embodiment, a case is described in which the frequency divider 162 and the switching element 164 are provided inside the panel control section 130, but this is not limiting. The frequency divider 162 and switching element 164 may be provided outside the panel control section 130.

### - Second Exemplary Embodiment -

The structure of the radiation detector 26 of the radiation panel unit 20 is not limited; alternative structures thereof are possible. In the present exemplary embodiment, a case in which the present invention is applied to the radiation detector 26 with an alternative structure is described. The present exemplary embodiment includes structures and operations that are substantially the same as in the first exemplary embodiment; portions that are the same are mentioned accordingly and detailed descriptions thereof are not given.

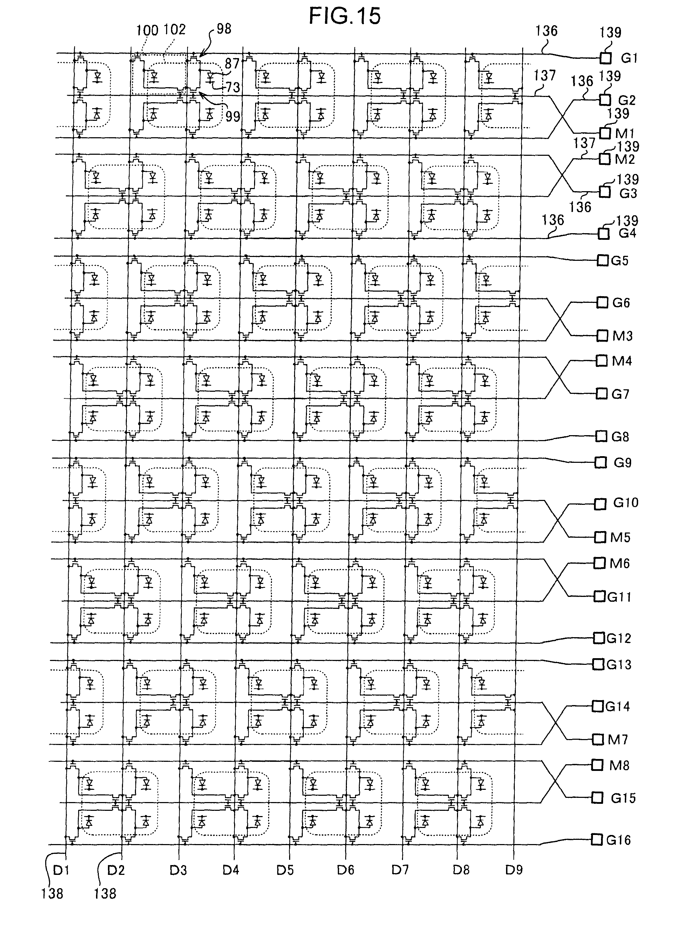

Fig. 15 shows the general structure of the radiation detector 26 according to the present exemplary embodiment. Similarly to the pixels 100 of the radiation detector 26 according to the first exemplary embodiment, the first TFTs 98 and second TFTs 99 are provided in the pixels 100 of the present exemplary embodiment of the radiation detector 26. However, the connections of the second TFTs 99 to the signal lines 138 are different. In the present exemplary embodiment, pixel groups 102 that are adjacent in the direction of the signal lines 138 output charges to different ones of the signal lines 138 (D1 to D9). That is, in the radiation detector 26 according to the present exemplary embodiment, the pixel groups 102 are arrayed in a staggered pattern as shown in Fig. 15.

In the first exemplary embodiment, the signal lines 138 for cases of low resolution imaging (Dm) and the signal lines 138 for high resolution imaging (Dg) are provided. In the present exemplary embodiment, however, the signal lines 138 (D) are used for both low resolution imaging and high resolution imaging; the signal lines 138 are not provided for particular kinds of imaging.

In the radiation detector 26 according to the present exemplary embodiment, the connection terminals 139 for providing connections to the gate circuit 132 (the gate drivers 150) are connected to the first gate lines 136 and the second gate lines 137 in an altered order. Specifically, as shown in Fig. 15, in the radiation detector 26, the first gate line 136 (G2) is interchanged in the sequence with the second gate line 137 (M1), and the first gate line 136 (G3) is interchanged in the sequence with the second gate line 137 (M2). Hence, the first gate lines 136 and the second gate lines 137 are similarly interchanged in sequence, as is illustrated in Fig. 15.

Thus, in the radiation detector 26 according to the present exemplary embodiment, because of the first gate lines 136 and the second gate lines 137 being arranged so as to be interchanged in being connected to the connection terminals 139, the first gate lines 136 are disposed to succeed one another and the second gate lines 137 are disposed to succeed one another. As a result, the above-described control by the panel control section 130 of the radiation detector 26 may be made easier. For example, the number of control cycles to turn the switching element 164 on and off, connecting and not connecting via the frequency divider 162, may be reduced.

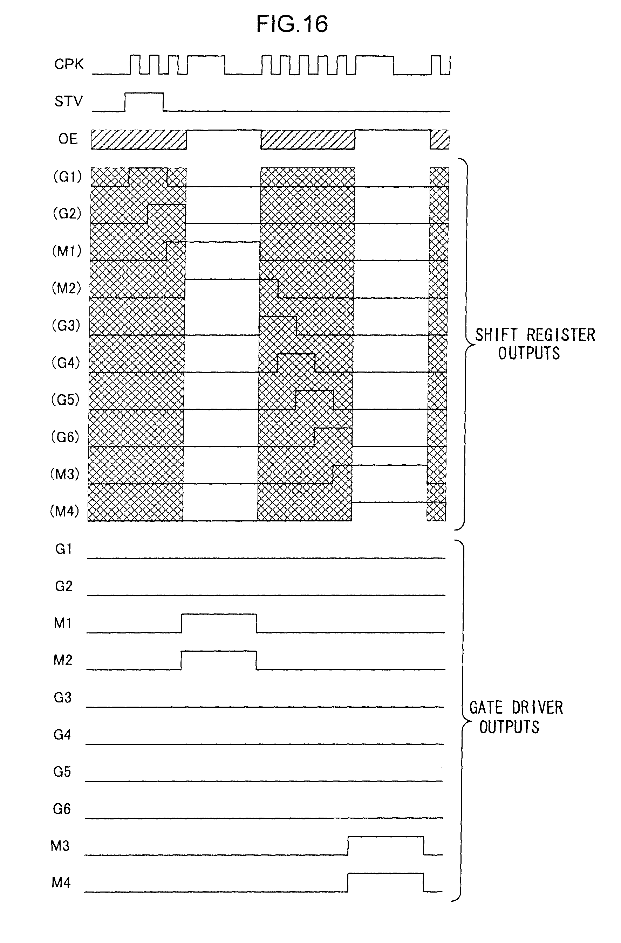

The driving sequence of the gate drivers 150 according to the present exemplary embodiment is described in detail. Firstly, the driving sequence of the gate drivers 150 for low resolution imaging is described. Fig. 16 shows a timing chart illustrating the driving sequence of the gate drivers 150 in the case of low resolution imaging.

Firstly, the STV signal inputted to the initial (first stage) shift register 152 rises. Then, when the CPK signal rises, an on signal (G1) is outputted from the first stage shift register 152. At this time, the OE signal is at the low level. Therefore, this on signal (G1) is not outputted to the first gate line 136, and no on signal is outputted from the gate driver 150 to the first gate line 136. Accordingly, charges are not read from the pixels 100. At this time, the period of the CPK signals is shorter than the usual period. At the time at which the CPK signal rises after the STV signal has fallen, this on signal (G1) is fixed at a potential that keeps the TFTs (the first TFTs 98 and the second TFTs 99) turned off (in the present exemplary embodiment, the potential Vgl).

The on signal (G1) outputted from the first shift register 152 is inputted to the succeeding shift register 152. An on signal (G2) is outputted from the succeeding shift register 152 in response to the on signal (G1) and a rise of the CPK signal. At this time, the OE signal is still at the low level. Therefore, the on signal (G2) is not outputted to the first gate line 136, and no on signal is outputted from the gate driver 150 to the first gate line 136. Accordingly, charges are not read from the pixels 100.

The on signal (G2) outputted from this second stage shift register 152 is inputted to a succeeding shift register. An on signal (M1) is outputted from the succeeding shift register 152 in response to the on signal (G2) and a rise of the CPK signal. At this time, the OE signal is at the high level. Therefore, the on signal (M1) is outputted to the second gate line 137, and an on signal is outputted from the gate driver 150 to the second gate line 137. Accordingly, charges are read out from the pixel groups 102 and outputted to the signal lines 138. At this time, the period of the CPK signals is the usual period.

The on signal (M1) outputted from this third stage shift register 152 is inputted to a succeeding shift register. At the succeeding shift register 152, an on signal (M1) is outputted to the second gate line 137 in the same manner as at the preceding shift register 152. Thus, an on signal is outputted from the gate driver 150 to the second gate line 137. Accordingly, charges are read out from the pixel groups 102 and outputted to the signal lines 138.

Hence, the above operations are repeated sequentially along the line of shift registers 152.

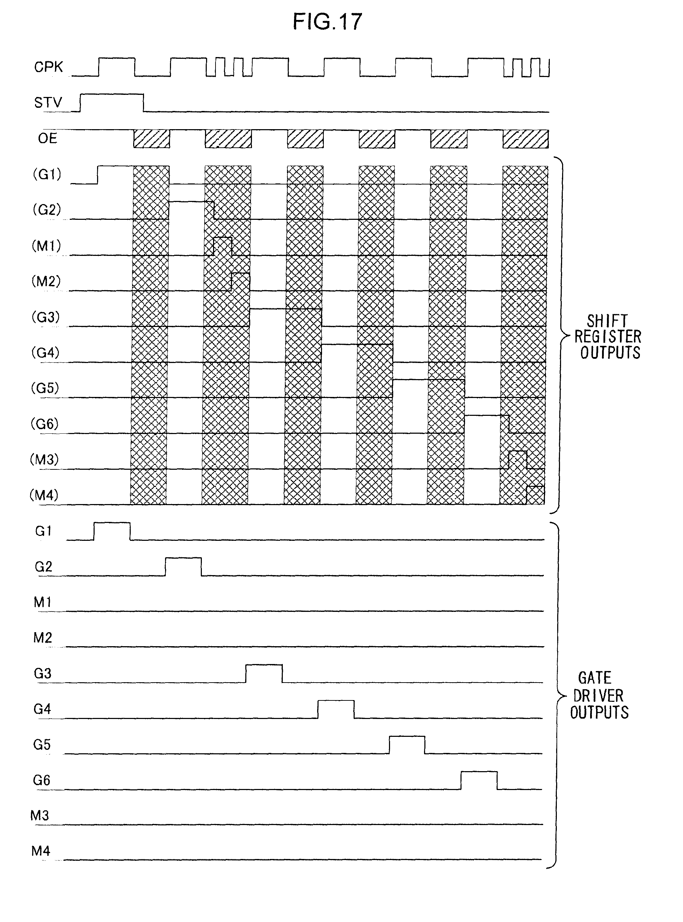

Now, the case of high resolution imaging is described. Fig. 17 shows a timing chart illustrating the driving sequence of the gate drivers 150 for high resolution imaging.

Firstly, the STV signal inputted to the initial (first stage) shift register 152 rises. Then, when the CPK signal rises, an on signal (G1) is outputted from the first stage shift register 152. At this time, the OE signal is at the high level. Therefore, this on signal (G1) is outputted to the first gate line 136, and an on signal is outputted from the gate driver 150 to the first gate line 136. Accordingly, charges are read out from the pixels 100. At this time, the period of the CPK signals is the usual period. At the time at which the CPK signal rises after the STV signal has fallen, this on signal (G1) is fixed at a potential that keeps the TFTs (the first TFTs 98 and the second TFTs 99) turned off (in the present exemplary embodiment, the potential Vgl).

The on signal (G1) outputted from the first shift register 152 is inputted to the succeeding shift register 152. An on signal (G2) is outputted from the succeeding shift register 152 in response to the on signal (G1) and a rise of the CPK signal. At this time, the OE signal is still at the high level. Therefore, the on signal (G2) is outputted to the first gate line 136, and an on signal is outputted from the gate driver 150 to the first gate line 136. Accordingly, charges are read out from the pixels 100.

The on signal (G2) outputted from this second stage shift register 152 is inputted to a succeeding shift register. An on signal (M1) is outputted from the succeeding shift register 152 in response to the on signal (G2) and a rise of the CPK signal. At this time, the OE signal is at the low level. Therefore, the on signal (M1) is not outputted to the second gate line 137, and no on signal is outputted from the gate driver 150 to the second gate line 137. Accordingly, charges are not read from the pixel groups 102. At this time, the period of the CPK signals is shorter than the usual period.

The on signal (M1) outputted from this third stage shift register 152 is inputted to a succeeding shift register. At the succeeding shift register 152, in the same manner as at the preceding shift register 152, the on signal (M1) is not outputted to the second gate line 137, and no on signal is outputted from the gate driver 150 to the second gate line 137. Accordingly, charges are not read from the pixel groups 102.

Hence, the above operations are repeated sequentially along the line of shift registers 152.

Thus, in the present exemplary embodiment too, the same as in the first exemplary embodiment described above, the first gate lines 136 and the second gate lines 137 are connected via the connection terminals 139 in accordance with the wiring of the radiation detector 26. In the case of low resolution imaging, the panel control section 130 outputs the OE signals that disable the output of on signals from the shift registers 152 to the first gate lines 136 in accordance with the CPK signals. In the case of high resolution imaging, the OE signals that disable the output of on signals from the shift registers 152 to the second gate lines 137 are outputted. Therefore, similarly to the first exemplary embodiment, the radiation panel unit 20 according to the present exemplary embodiment may capture radiation images with a low resolution and with a high resolution using the general-purpose gate drivers 150 configured with the shift register 152 group in a single system.

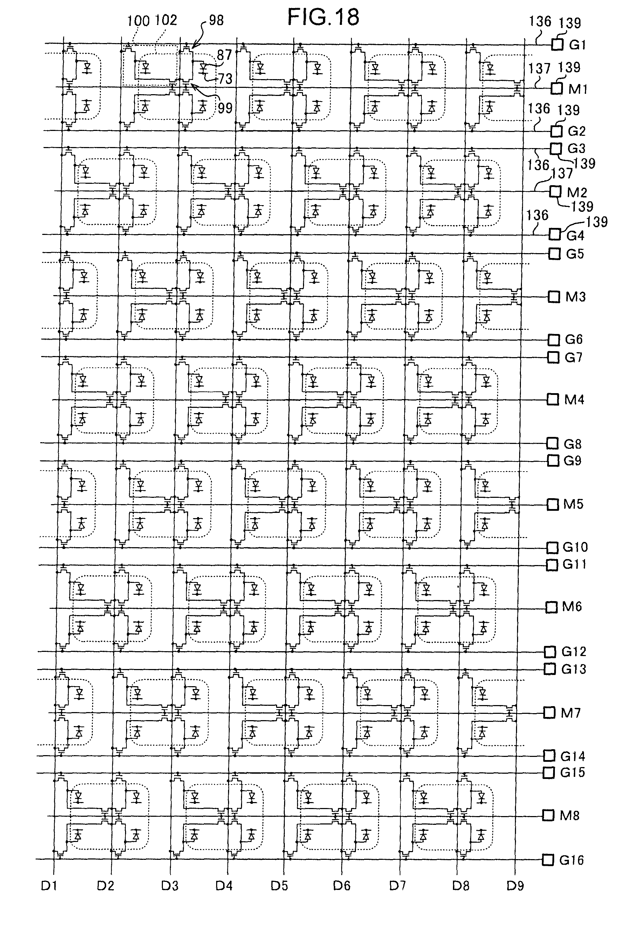

In the radiation panel unit 20 according to the present exemplary embodiment, because the first gate lines 136 and the second gate lines 137 are interchanged in sequence and arranged to be connected to the connection terminals 139 successively, control at the panel control section 130 may be made easier. However, this is not limiting. For example, as in the radiation detector 26 illustrated in Fig. 18, the first gate lines 136 and the second gate lines 137 may be arranged to not be interchanged in sequence. In this case, numbers of the first gate lines 136 that are successively disposed and of the second gate lines 137 that are successively disposed are lower. Therefore, because the number of cycles of control of the switching element 164 so as to connect via the frequency divider 162 is increased and the like, control is more complicated than in the radiation detector 26 illustrated in Fig. 15. Further, numbers (numbers of gate lines) of the first gate lines 136 and the second gate lines 137 that are respectively successive are not limited by the above descriptions. For example, an arrangement is possible such that the second gate lines 137 (M1 to M4) are successive. In this case, the wiring interchanging the sequence of the first gate lines 136 and the second gate lines 137 is more complicated than in the above descriptions. Therefore, there is concern that wiring capacitances may increase and complexity may rise. Thus, the numbers of the first gate lines 136 that are successive and the numbers of the second gate lines 137 that are successive should be specified with consideration for simplicity of control, wiring capacitances and so forth.

As a further example, the second gate line 137 (M1) and the second gate line 137 (M2) may be electronically connected to form a single second gate line 137 (M). In this case, there is a concern that the wiring capacitance load may be greater, and that the wiring capacitance may be greatly different from other gate lines (for example, the first gate lines 136 (G)). Therefore, in a case in which the load of wiring capacitances acting on gate lines is not great, the lines may be electronically connected as described above. On the other hand, a configuration such as that of the present exemplary embodiment (see Fig. 15) is preferable in regard to matching the wiring capacitances of all lines.

As is described in the above exemplary embodiments, the radiation panel unit 20 according to the present exemplary embodiments includes only the single gate circuit 132, and the gate circuit 132 is provided at one side of the radiation detector 26. The gate circuit 132 includes the gate drivers 150 that are provided with the shift register 152 group in a single system. Each shift register 152 is connected to a first gate line 136 or a second gate line 137 via a connection terminal 139 in accordance with the wiring of the radiation detector 26. In the case of low resolution imaging, the panel control section 130 outputs the OE signals that disable the output of on signals from the shift registers 152 to the first gate lines 136 in accordance with the CPK signals, under the control of the FPGA 131, and in the case of high resolution imaging, the panel control section 130 outputs the OE signals that disable the output of on signals from the shift registers 152 to the second gate lines 137. In both cases of imaging, the on signal outputted from each shift register 152 is inputted to the succeeding shift register 152. Thus, in the case of low resolution imaging, on signals are outputted from the gate drivers 150 only to the second gate lines 137, and in the case of high resolution imaging, on signals are outputted from the gate drivers 150 only to the first gate lines 136.

Therefore, the radiation panel unit 20 according to the present exemplary embodiment may capture radiation images with a low resolution and with a high resolution using the general-purpose gate drivers 150 configured with the shift register 152 group in a single system.

In the radiation panel unit 20 according to the present exemplary embodiments, the period of the CPK signals is made shorter than the usual period by the frequency divider 162 when the output of on signals is being disabled by the OE signals. In the exemplary embodiments as described above, in both low resolution imaging and high resolution imaging, the shift registers 152 corresponding with all of the gate lines (the first gate lines 136 and the second gate lines 137) are driven. Therefore, there is a concern that the overall driving duration of the shift registers 152 may be longer than in a case in which only driving corresponding to the first gate lines 136 is conducted or a case in which only the driving corresponding to the second gate lines 137 is conducted. Accordingly, in the radiation panel unit 20 a lengthening of the driving duration is suppressed and a fall in the frame rate is suppressed by the CPK signals being made shorter than the usual period when the on signals should not be outputted. Therefore, the radiation panel unit 20 may cope with an increase in the frame.

The pixels 100 (pixel groups 102) of the radiation detector 26 of the radiation panel unit 20 are not limited by the exemplary embodiments described above. For example, in the above descriptions, the pixel groups 102 are described as being arrayed in a staggered pattern in the radiation detector 26. However, as in the radiation detector 26 illustrated in Fig. 20, the pixel groups 102 may be arrayed in a lattice pattern. Moreover, in the above descriptions a case is described in which each pixel group 102 contains two by two of the pixels 100. However, as in the radiation detector 26 illustrated in Fig. 21, each pixel group 102 may contain four by four of the pixels 100.

The radiation detector 26 is not limited by the exemplary embodiments described above provided it may be used to capture radiation images at different resolutions; the technologies recited in JP-A No. 2009-267326 and the like may be employed. For example, the photoelectric conversion film 86 may contain amorphous silicon. Further, the insulating substrate 93 or 122 may be a glass board.

The number of the gate drivers 150 is not particularly limited by the numbers of the respectively connected first gate lines 136 and second gate lines 137, and may be determined in accordance with specifications of the radiation panel unit 20 and the like.

In the present exemplary embodiments, the TFTs that are used for the first TFTs 98 and second TFTs 99 that read out charges from the pixels 100 are, as illustrated in Fig. 11 to Fig. 14, Fig. 16 and Fig. 17, TFTs whose gates turn on when a positive gate-on voltage is applied, but this is not limiting. For example, TFTs whose gates turn on when a negative gate-on voltage is applied may be used.

Shapes of the pixels 100 are not limited by the present exemplary embodiment. For example, although rectangular pixels 100 are illustrated in the present exemplary embodiments, the shape of the pixels 100 is not limited to a rectangular shape and may be an alternative shape. The arrangement of the pixels 100 is also not limited by the present exemplary embodiments. For example, as a mode in which the pixels 100 are arranged in rows and columns, a case in which the pixels 100 are arranged with regularity in a rectangular pattern is illustrated. However, modes are not limited provided the pixels 100 are arranged with regularity in two dimensions.

The arrangement of the gate lines and the signal lines 138 may be put into a mode in which, in contrast to the present exemplary embodiments, the signal lines 138 are arranged in the row direction and the gate lines 136 are arranged in the column direction.

In other respects, structures, operations and the like of the radiation image capture system 10, the radiation panel unit 20, the radiation detection device 26, the gate driver 150 and the like described in the above exemplary embodiments are examples and it will it clear that these may be modified in accordance with conditions within a scope not departing from the spirit of the present invention.

The radiation X mentioned in the above exemplary embodiments is not particularly limited; X-rays, gamma rays and so forth may be employed.[0135] The disclosures of Japanese Patent Application No. 2012-123626 are incorporated into the present specification by reference in their entirety.

All references, patent applications and technical specifications cited in the present specification are incorporated by reference into the present specification to the same extent as if the individual references, patent applications and technical specifications were specifically and individually recited as being incorporated by reference.

### Explanation of Reference Numerals

- 10: Radiation imaging system
- 20: Radiation panel unit
- 26: Radiation detector
- 98, 128: First TFTs
- 99, 129: Second TFTs
- 100: Pixels
- 102: Pixel groups
- 130: Panel control section
- 132: Gate circuit
- 136: First gate lines (G)
- 137: Second gate lines (M)
- 138: Signal lines 138 (D, Dg, Dm)
- 150: Gate driver
- 152: Shift register
- 160: Signal generation section
- 162: Frequency divider

## Claims

1. A radiation imaging device comprising:
a plurality of pixels arrayed in a two-dimensional pattern, each pixel including
a sensor portion that generates charges in accordance with irradiated radiation,
a first switching element that, in accordance with driving signals, reads out the charges from the sensor portion and outputs the charges, and
a second switching element that, in accordance with driving signals, reads out the charges from the sensor portion and outputs the charges;
a control line group including
a plurality of first control lines connected to control terminals of the first switching elements of pluralities of the pixels that are adjacent in a first direction according to the array of the pixels, and
a plurality of second control lines connected to control terminals of the second switching elements of pluralities of the pixels that are adjacent in the first direction and to control terminals of the second switching elements of the pixels that are adjacent in a second direction crossing the first direction;
a signal line group including a signal line for each pixel in the second direction,
output terminals of the first switching elements of pluralities of the pixels that are adjacent in the second direction being connected to each of the signal lines, and
output terminals of the second switching elements of pluralities of the pixels that are adjacent in the second direction and output terminals of the second switching elements of pluralities of the pixels that are adjacent in the first direction being connected to some of the signal lines;
a driver including a shift register group that sequentially outputs driving signals to the control lines in accordance with inputted clock signals; and
a controller that,
in a case of reading charges with the first switching elements, controls such that driving signals outputted from the shift registers are outputted to the first control lines but are not outputted to the second control lines and,
in a case of reading charges with the second switching elements, controls such that the driving signals outputted from the shift registers are not outputted to the first control lines but are outputted to the second control lines.

2. The radiation control device according to claim 1 wherein, in the case of reading charges with the second switching elements, the controller controls to make a period of the clock signals inputted to the shift registers that correspond with the first control lines shorter than a period of the clock signals inputted to the shift registers that correspond with the second control lines.

3. The radiation imaging device according to claim 1 or claim 2 wherein, in the case of reading charges with the first switching elements, the controller controls to make a period of the clock signals inputted to the shift registers that correspond with the second control lines shorter than a period of the clock signals inputted to the shift registers that correspond with the first control lines.

4. The radiation imaging device according to any one of claims 1 to 3, wherein a plurality of the shift registers that output driving signals to the first control lines are adjacent, and a plurality of the shift registers that output driving signals to the second control lines are adjacent.

5. The radiation imaging device according to any one of claims 1 to 3, wherein the first control lines and second control lines provided in accordance with the array of the pixels are interchanged in a sequence of connection to the driver, a plurality of the shift registers that output driving signals to the first control lines are adjacent, and a plurality of the shift registers that output driving signals to the second control lines are adjacent.

6. The radiation imaging device according to any one of claims 1 to 5 wherein,
in the case of reading charges with the first switching elements, the controller outputs disable signals to the shift registers that correspond with the second control lines in accordance with the inputted clock signals, the disable signals disabling output to the second control lines of the driving signals outputted from the shift registers, and,
in the case of reading charges with the second switching elements, the controller outputs disable signals to the shift registers that correspond with the first control lines in accordance with the inputted clock signals, the disable signals disabling output to the first control lines of the driving signals outputted from the shift registers.

7. The radiation imaging device according to any one of claims 1 to 6, wherein the controller includes a frequency divider, and the controller inputs the clock signals to the shift registers via the frequency divider in cases in which the period of the clock signals is to be made shorter.

8. A radiation imaging system comprising:
a radiation irradiation device; and
a radiation imaging device according to any one of claims 1 to 7 that detects radiation irradiated from the radiation irradiation device.

9. A control method of a radiation imaging device that includes:
a plurality of pixels arrayed in a two-dimensional pattern, each pixel including
a sensor portion that generates charges in accordance with irradiated radiation,
a first switching element that, in accordance with driving signals, reads out the charges from the sensor portion and outputs the charges, and
a second switching element that, in accordance with driving signals, reads out the charges from the sensor portion and outputs the charges;
a control line group including
a plurality of first control lines connected to control terminals of the first switching elements of pluralities of the pixels that are adjacent in a first direction according to the array of the pixels, and
a plurality of second control lines connected to control terminals of the second switching elements of pluralities of the pixels that are adjacent in the first direction and to control terminals of the second switching elements of the pixels that are adjacent in a second direction crossing the first direction;
a signal line group including a signal line for each pixel in the second direction,
output terminals of the first switching elements of pluralities of the pixels that are adjacent in the second direction being connected to each of the signal lines, and
output terminals of the second switching elements of pluralities of the pixels that are adjacent in the second direction and output terminals of the second switching elements of pluralities of the pixels that are adjacent in the first direction being connected to some of the signal lines; and
a driver including a shift register group that sequentially outputs driving signals to the control lines in accordance with inputted clock signals,
the radiation imaging device control method comprising:
in a case of reading charges with the first switching elements, controlling with a controller such that driving signals outputted from the shift registers are outputted to the first control lines but are not outputted to the second control lines; and,
in a case of reading charges with the second switching elements, controlling with the controller such that the driving signals outputted from the shift registers are not outputted to the first control lines but are outputted to the second control lines.

10. A control program of a radiation imaging device that includes:
a plurality of pixels arrayed in a two-dimensional pattern, each pixel including
a sensor portion that generates charges in accordance with irradiated radiation,
a first switching element that, in accordance with driving signals, reads out the charges from the sensor portion and outputs the charges, and
a second switching element that, in accordance with driving signals, reads out the charges from the sensor portion and outputs the charges;
a control line group including
a plurality of first control lines connected to control terminals of the first switching elements of pluralities of the pixels that are adjacent in a first direction according to the array of the pixels, and
a plurality of second control lines connected to control terminals of the second switching elements of pluralities of the pixels that are adjacent in the first direction and to control terminals of the second switching elements of the pixels that are adjacent in a second direction crossing the first direction;
a signal line group including a signal line for each pixel in the second direction,
output terminals of the first switching elements of pluralities of the pixels that are adjacent in the second direction being connected to each of the signal lines, and
output terminals of the second switching elements of pluralities of the pixels that are adjacent in the second direction and output terminals of the second switching elements of pluralities of the pixels that are adjacent in the first direction being connected to some of the signal lines; and
a driver including a shift register group that sequentially outputs driving signals to the control lines in accordance with inputted clock signals,
the radiation imaging device control program causing a computer to function as a controller that performs control comprising:
in a case of reading charges with the first switching elements, controlling such that driving signals outputted from the shift registers are outputted to the first control lines but are not outputted to the second control lines; and,
in a case of reading charges with the second switching elements, controlling such that the driving signals outputted from the shift registers are not outputted to the first control lines but are outputted to the second control lines.
